# EUROPÄISCHE PATENTSCHRIFT

(11) **EP 2 944 984 B1**
(45) Veröffentlichungstag und Bekanntmachung des Hinweises auf die Patenterteilung: **08.06.2022**
(21) Anmeldenummer: 14167921.7
(22) Anmeldetag: 12.05.2014
(51) Int. Cl.: G01V 8/10, H03K 5/003

(54) **VERFAHREN ZUM BEARBEITEN EINES START-SIGNALZUGS UND MESS- ODER PRÜFVORRICHTUNG**
METHOD FOR PROCESSING A START SIGNAL TRAIN AND MEASURING OR TESTING DEVICE
PROCÉDÉ DE TRAITEMENT D'UN TRAIN DE SIGNAUX DE DÉMARRAGE ET DISPOSITIF DE CONTRÔLE OU DE MESURE

(43) Veröffentlichungstag der Anmeldung: 18.11.2015
(73) Patentinhaber: BALLUFF GmbH, 73765 Neuhausen (DE)
(72) Erfinder: Fingerle, Bernd, 72667 Schlaitdorf (DE); Grabe, Eckart, 70794 Filderstadt (DE)
(74) Vertreter: Hoeger, Stellrecht & Partner Patentanwälte mbB

(56) Entgegenhaltungen:
- EP-A1- 2 226 651
- US-A- 5 008 531
- US-A1- 2006 276 153
- US-A1- 2008 315 943
- US-A1- 2012 133 412

## Beschreibung

Die Erfindung betrifft ein Verfahren zum Bearbeiten eines Start-Signalzugs, welcher einen ersten Anteil mit periodischen Pulsen umfasst, wobei die Pulse unipolar zu einer Referenz ausgelenkt sind, und einen zweiten Anteil umfassen kann, welcher ein Störanteil mit Gleichsignalen ist, bei dem aus dem Start-Signalzug ein Gleichsignal-unterdrückter Signalzug erzeugt wird.

Die Erfindung betrifft ferner eine Mess- oder Prüfvorrichtung, umfassend eine Einheit, welche Start-Signalzüge bereitstellt, die einen ersten Anteil mit periodischen Pulsen aufweisen, welche eine unipolare Auslenkung gegenüber einer Referenz haben, und die einen zweiten Anteil aufweisen können, welcher ein Störanteil mit Gleichsignalen ist.

Die US 2012/0133412 A1 offenbart einen Schaltkreis, welcher eine Zeitdomänen-Verarbeitungssequenz an einem modulierten Eingabesignal anwendet, um einen Mittelwert eines modulierten Eingabesignals abzuschätzen und den abgeschätzten Mittelwert von dem modulierten Eingabesignal abzuziehen. Es wird dadurch ein Gleichstrom-Offset von dem Eingabesignal entfernt.

Die US 2006/0276153 A1 offenbart ein Verfahren zur Entfernung eines DC-Offsets in einem Signalpfad eines Zero-IF-Empfängers.

Die US 2008/03159543 A1 offenbart einen Anti-Jitter-Schaltkreis.

Der Erfindung liegt die Aufgabe zugrunde, ein Verfahren der eingangs genannten Art bereitzustellen, mittels welchem sich Signalzüge gewinnen lassen, die minimal fehlerbehaftet sind.

Diese Aufgabe wird bei dem eingangs genannten Verfahren erfindungsgemäß dadurch gelöst, dass der Gleichsignal-unterdrückte Signalzug aus dem Start-Signalzug durch Gleichsignalunterdrückung oder Wechselsignalankopplung erzeugt wird, aus dem Gleichsignal-unterdrückten Signalzug ein Gleichanteil des ersten Anteils des Start-Signalzugs als Korrekturwert ermittelt wird, wobei der Korrekturwert zur Rückgewinnung des Gleichanteils des ersten Anteils des Start-Signalzugs durch eine bezüglich der Referenz polaritätsabhängige Funktion ermittelt wird, und der Korrekturwert aus einem Anteil des Gleichsignal-unterdrückten Signalzugs ermittelt wird, welcher gegenüber der Referenz eine entgegengesetzte Polarität zu der unipolaren Auslenkung hat, und der Korrekturwert in Pausenzeiten zwischen Pulsen ermittelt wird, und dieser Korrekturwert vorzeichenrichtig zu dem Gleichsignal-unterdrückten Signalzug addiert wird, wobei ein korrigierter Ergebnis-Signalzug resultiert.

Der Start-Signalzug umfasst den ersten Anteil mit periodischen Pulsen und kann den zweiten Anteil mit Gleichsignalen umfassen. Der für eine Auswertung relevante Anteil ist der erste Anteil, welcher beispielsweise direkt mit Sendepulsen korreliert ist. Der zweite Anteil kann beispielsweise durch Offset-Spannungen im System entstehen. Bei einem optoelektronischen System kann der zweite Anteil beispielsweise auf Streulicht zurückzuführen sein.

Grundsätzlich ist der zweite Anteil (näherungsweise) eliminierbar, indem der Gleichsignal-unterdrückte Signalzug durch Gleichsignalunterdrückung hergestellt wird. Die Gleichsignalunterdrückung kann durch entsprechende Filter bzw. Wechselsignalankopplung erreicht werden. Es besteht dabei jedoch das grundsätzliche Problem, dass auch der erste Anteil einen Gleichanteil enthält, welcher gewissermaßen miteliminiert wird. Der Gleichsignal-unterdrückte Signalzug liefert damit nicht den ersten Anteil, sondern weist einen systematischen Fehler auf.

Wenn die Pulse im ersten Anteil unipolar bezüglich der Referenz ausgelenkt sind, das heißt einseitig ausgelenkt sind, dann weist üblicherweise der Gleichsignal-unterdrückte Signalzug auch einen Signalanteil auf, welcher eine Polarität entgegengesetzt zu dieser einseitigen Auslenkung aufweist. Ferner sind Scheitelwerte (Maximalwerte) des Gleichsignal-unterdrückten Signalzugs bezogen auf die Referenz kleiner als entsprechende Maximalwerte in dem ersten Anteil.

Erfindungsgemäß wird aus dem Gleichsignal-unterdrückten Signalzug ein Gleichanteil des ersten Anteils des Start-Signalzugs als Korrekturwert ermittelt, und dieser Korrekturwert wird dann wieder vorzeichenrichtig zu dem Gleichsignal-unterdrückten Signalzug addiert. In dem dabei entstehenden korrigierten Ergebnis-Signalzug ist der systematische Fehler, der durch eine "pauschale Abziehung" des Gleichsignalanteils vom Start-Signalzug erzeugt wurde, korrigiert. Der korrigierte Ergebnis-Signalzug stimmt mindestens näherungsweise mit dem ersten Anteil überein. Es ist dadurch eine Fehlerkorrektur realisiert.

Das erfindungsgemäße Verfahren verhindert auch einen entsprechenden systematischen Fehler, wenn der Start-Signalzug keinen zweiten Anteil umfasst. Wenn der Gleichsignal-unterdrückte Signalzug hergestellt wird, wird der Gleichanteil im ersten Anteil unterdrückt. Durch das erfindungsgemäße Verfahren wird der entsprechende Korrekturwert ermittelt und es wird dann wieder der Gleichanteil rückgewonnen.

Ein fehlerkorrigierter Signalzug gemäß dem erfindungsgemäßen Verfahren lässt sich insbesondere auf einfache Weise weiterverarbeiten.

Das erfindungsgemäße Verfahren ist durchführbar, unabhängig davon, in welcher Richtung die unipolare Auslenkung ist, das heißt unabhängig davon, ob die unipolare Auslenkung in positiver oder negativer Richtung ist.

Insbesondere liegen in dem ersten Anteil des Start-Signalzugs Pulse zwischen einem betragsmäßigen Minimalwert und einem betragsmäßigen Maximalwert, wobei der betragsmäßige Minimalwert bei der Referenz liegt. Die unipolare Auslenkung ist dann die Auslenkung ausgehend von dem betragsmäßigen Minimalwert (der Referenz) zu dem betragsmäßigen Maximalwert hin. Das erfindungsgemäße Verfahren ist unabhängig davon, in welcher Richtung die unipolare Auslenkung der Pulse ist. Der Minimalwert und der Maximalwert sind deshalb auf den entsprechenden Betrag bezogen.

Ein nutzbarer Signalzug wird insbesondere in Relation zu der Referenz verwendet und insbesondere wird eine referenzbezogene Maximalwert-Auswertung (bezogen auf den betragsmäßigen) durchgeführt. Bei dem Gleichsignal-unterdrückten Signalzug ist eine solche Maximalwert-Auswertung fehlerbehaftet, da der Maximalwert im Gleichsignal-unterdrückten Signalzug kleiner ist als bei dem ersten Anteil. Dieser systematische Fehler wird durch das erfindungsgemäße Verfahren mit der Ermittlung des Korrekturwerts eliminiert.

Der Gleichsignal-unterdrückte Signalzug wird aus dem Start-Signalzug durch Gleichsignalunterdrückung (wie Filterung) oder Wechselsignalankopplung erzeugt.

Insbesondere sind Scheitelwerte von Pulsen im Ergebnis-Signalzug in Relation zu der Referenz mindestens näherungsweise gleich groß wie Scheitelwerte von Pulsen im ersten Anteil des Start-Signalzugs in Relation zu der Referenz. Durch das erfindungsgemäße Verfahren kann der erste Anteil des Start-Signalzugs generiert werden; der korrigierte Ergebnis-Signalzug stimmt mindestens näherungsweise mit dem ersten Anteil des Start-Signalzugs überein. Der erste Anteil des Start-Signalzugs wiederum korreliert mit einem entsprechenden Messsignal bzw. Prüfsignal bzw. bildet dieses.

Beispielsweise ist die Referenz ein Referenzwert oder Referenzsignal und insbesondere ein Nullsignal oder ein Massepotential. Eine solche Referenz lässt sich auf einfache Weise einstellen. Grundsätzlich kann die Referenz aber auch beispielsweise ein beliebiger endlicher Spannungswert oder Stromwert sein.

Es erfolgt die Ermittlung des Korrekturwerts zur Rückgewinnung des Gleichanteils des ersten Anteils des Start-Signalzugs durch eine bezüglich der Referenz polaritätsabhängige Funktion. Die polaritätsabhängige Funktion erkennt in dem Gleichsignal-unterdrückten Signalzug Anteile mit entgegengesetzter Polarität zu der unipolaren Auslenkung im ersten Anteil. Daraus wiederum lässt sich der Korrekturwert auf einfache Weise ermitteln. Die polaritätsabhängige Funktion lässt sich über unterschiedliche Hardware-Elemente wie Gleichrichter, Komparatoren, Schalter usw. realisieren.

Der Korrekturwert wird aus einem Anteil des Gleichsignal-unterdrückten Signalzugs ermittelt, welcher gegenüber der Referenz eine entgegengesetzte Polarität zu der unipolaren Auslenkung hat. Diese Ermittlung lässt sich mit minimiertem konstruktiven Aufwand auf einfache Weise durchführen.

Der Korrekturwert wird in Pausenzeiten zwischen Pulsen ermittelt. Eine solche Ermittlung lässt sich auf einfache Weise beispielsweise mit Hilfe von einem oder mehreren Komparatoren durchführen.

Günstig ist es, wenn ein Signalzug aufgeteilt wird in einen ersten Split-Signalzug und einen zweiten Split-Signalzug, wobei an dem zweiten Split-Signalzug der Korrekturwert bestimmt wird. Dadurch lässt sich auf einfache Weise ein durch die Erzeugung des Gleichsignal-unterdrückten Signalzugs hervorgerufener systematischer Fehler beheben.

Bei einem Ausführungsbeispiel erfolgt die Aufteilung vor einem Addierer, indem der Korrekturwert zu dem ersten Split-Signalzug addiert wird, wobei der aufgeteilte Signalzug der Gleichsignal-unterdrückte Signalzug ist. Es lässt sich dadurch ein einfacher Aufbau einer entsprechenden Schaltung realisieren.

Bei einem Ausführungsbeispiel erfolgt die Aufteilung nach einem Addierer, indem der Korrekturwert zu dem Gleichsignal-unterdrückten Signalzug addiert wird, und insbesondere wobei der erste Split-Signalzug der korrigierte Ergebnis-Signalzug ist. Es lässt sich dann insbesondere ein Regelkreis realisieren. In einem solchen Regelkreis können beispielsweise zusätzliche aufbaubedingte Offsetfehler reduziert werden. Beispielsweise kann auch eine zusätzliche Hochpass-Filterwirkung an einem Ausgang durch eine Rückkopplung eines tiefpassgefilterten Signals erreicht werden.

Beispielsweise wird der Korrekturwert mittels eines Tiefpassfilters und/oder Integrators ermittelt. Es lässt sich so eine Restwelligkeit bzw. ein Rauschen reduzieren. Ferner können die unterschiedlichen Signalpfade auf Frequenzverhalten und Einschwingverhalten angeglichen werden.

Bei einem Ausführungsbeispiel wird über eine polaritätsabhängige Funktion ein Signalweg zu einem Tiefpassfilter und/oder Integrator unterbrochen oder freigegeben, wobei insbesondere bei einer zu der unipolaren Auslenkung entgegengesetzten Polarität in einem Signalzug der Signalweg freigegeben wird. Es lässt sich dadurch auf einfache Weise ermitteln, wie ein entsprechender Signalanteil gegenüber der Referenz mit entgegengesetzter Polarität zu der Richtung der unipolaren Auslenkung verschoben wurde. Daraus wiederum lässt sich dann auf einfache Weise der Korrekturwert bestimmen.

Beispielsweise wird der Signalweg mittels eines Einweggleichrichters und/oder eines Schalters und/oder eines Komparators unterbrochen oder freigegeben. Ein Einweggleichrichter führt insbesondere eine Gleichrichtung bezüglich einer Referenz (üblicherweise zu der Referenzspannung Null bzw. zu einem Massepotential) durch. Über einen Komparator kann ein Vergleich zu der Referenz durchgeführt werden. Insbesondere steuert dann der Komparator einen Schalter an.

Bei einer Ausführungsform wird der Schalter über einen Komparator angesteuert, welcher einen Signalzug mit der Referenz vergleicht.

Für eine vorzeichenrichtige Addition des Korrekturwerts zu dem Gleichsignal-unterdrückten Signalzug ist es wichtig, dass ein durch die Gleichsignalunterdrückung zu viel abgezogener Anteil wieder dazu addiert wird.

Eine vorzeichenrichtige Addition kann beispielsweise dadurch erreicht werden, dass die Invertierung bei der Gewinnung des Korrekturwerts durchgeführt wird oder an einem Addierer-Eingang durchgeführt wird.

Bei einem Ausführungsbeispiel wird an einem zweiten Split-Signalzug des Gleichsignal-unterdrückten Signalzugs eine Einweggleichrichtung und anschließend eine Filterung und/oder Integration durchgeführt und der sich daraus ergebende Korrekturwert wird vorzeichenrichtig zu einem ersten Split-Signalzug des Gleichsignal-unterdrückten Signalzugs addiert. Ein solches Verfahren lässt sich mit einer geringen Anzahl von Schaltungskomponenten realisieren.

Bei einem weiteren Ausführungsbeispiel wird ein zweiter Split-Signalzug über einen Schalter einem Tiefpassfilter und/oder Integrator zugeführt, wobei der Schalter mittels eines Komparators angesteuert wird, welcher den zweiten Split-Signalzug mit der Referenz vergleicht, und bei der zu der unipolaren Auslenkung entgegengesetzten Polarität einen Signalweg zu dem Tiefpassfilter und/oder Integrator schaltet, und der sich dann ergebende Korrekturwert wird vorzeichenrichtig zu einem ersten Split-Signalzug des Gleichsignal-unterdrückten Signalzugs addiert. Ein solches Verfahren lässt sich insbesondere auch anwenden, wenn die Referenz kein Nullpotential oder Massepotential ist.

Bei einer weiteren Ausführungsform wird eine polaritätsabhängige Funktion zur Ermittlung des Korrekturwerts über einen Regelkreis bestimmt, bei dem der Korrekturwert vorzeichenrichtig zu dem Gleichsignal-unterdrückten Signalzug addiert wird und aus dem resultierenden Signalzug wird ein erster Split-Signalzug abgezweigt, welcher der korrigierte Ergebnis-Signalzug ist, und es wird ein zweiter Split-Signalzug abgezweigt, an welchem der Korrekturwert bestimmt wird. Über einen Regelkreis lässt sich eine verbesserte Fehlerelimination erreichen.

Beispielsweise wird der Korrekturwert über einen Schalter bestimmt, welcher mittels eines Komparators angesteuert wird, wobei der Komparator den zweiten Split-Signalzug mit der Referenz vergleicht, wobei der Schalter über einen Signalweg mit dem Tiefpassfilter und/oder Integrator verbunden ist. Es lässt sich dadurch auf einfache Weise die polaritätsabhängige Funktion realisieren.

Es ist auch möglich, dass der Korrekturwert über einen Komparator bestimmt wird, welcher einen zweiten Split-Signalzug mit der Referenz vergleicht und einen Tiefpassfilter ansteuert. Als Tiefpassfilter kann beispielsweise ein abtastender, analoger Switched-Capacitor-Filter (SC-Filter) oder ein zeitdiskreter, digitaler Filter verwendet werden. Es ist dann insbesondere vorteilhaft, wenn der Komparator über ein ODER-Glied mit dem Tiefpassfilter verbunden ist, wobei das ODER-Glied über ein Steuersignal angesteuert ist, welches synchron zu dem Start-Signalzug und/oder dem ersten Anteil des Start-Signalzugs ist. Es lässt sich dadurch eine stets rechtzeitige Deaktivierung einer Tiefpassfilterfunktion bzw. Integratorfunktion erreichen, auch für Fälle, in denen der Start-Signalzug bzw. der Gleichsignal-unterdrückte Signalzug so niedrig ist, dass noch nicht ein Komparatorschwellenwert überschritten wird.

Insbesondere ist der erste Anteil des Start-Signalzugs ein periodisches Messsignal oder Prüfsignal und der zweite Anteil ist ein Störanteil. Der erste Anteil korreliert insbesondere direkt mit einem Sendesignal bzw. primären Signal.

Erfindungsgemäß wird eine Mess- oder Prüfvorrichtung der eingangs genannten Art bereitgestellt, umfassend eine Einheit, welche Start-Signalzüge bereitstellt, die einen ersten Anteil mit periodischen Pulsen aufweisen, welche eine unipolare Auslenkung gegenüber einer Referenz haben, und die einen zweiten Anteil aufweisen können, welcher ein Störanteil mit Gleichsignalen ist, eine Signalbearbeitungseinrichtung, welche korrigierte Ergebnis-Signalzüge bereitstellt, wobei die Signalbearbeitungseinrichtung eine Gleichsignalunterdrückungseinrichtung aufweist, welche aus den Start-Signalzügen Gleichsignal-unterdrückte Signalzüge erzeugt, wobei die Signalbearbeitungseinrichtung eine Rückgewinnungseinrichtung aufweist, welche aus den Gleichsignal-unterdrückten Signalzügen einen Gleichanteil des ersten Anteils der Start-Signalzüge als Korrekturwerte ermittelt, wobei die Rückgewinnungseinrichtung einen Tiefpassfilter und/oder Integrator umfasst, welcher Korrekturwerte bereitstellt, und wobei dem Tiefpassfilter und/oder Integrator Signale über einen Einweggleichrichter und/oder Schalter und/oder Komparator bereitgestellt sind, welche eine polaritätsabhängige Funktion in Bezug auf die Referenz bereitstellen, und wobei die Signalbearbeitungseinrichtung einen Addierer aufweist, welcher zur Gewinnung der Ergebnis-Signalzüge vorzeichenrichtig Korrekturwerte zu den Gleichsignal-unterdrückten Signalzügen addiert.

An der erfindungsgemäßen Mess- oder Prüfvorrichtung lässt sich das erfindungsgemäße Verfahren durchführen.

Vorteile der erfindungsgemäßen Mess- oder Prüfvorrichtung wurden bereits im Zusammenhang mit dem erfindungsgemäßen Verfahren erläutert.

Insbesondere ist ein Splitter vorgesehen, welcher Signalzüge in erste Split-Signalzüge und zweite Split-Signalzüge aufteilt, wobei der Rückgewinnungseinrichtung die zweiten Split-Signalzüge bereitgestellt sind. Es lässt sich so ein Korrekturwert auf einfache Weise ermitteln.

Bei einer Ausführungsform ist der Splitter dem Addierer vorgeschaltet, wobei an dem Splitter Gleichsignal-unterdrückte Signalzüge in erster Split-Signalzüge und zweite Split-Signalzüge aufgeteilt werden und wobei an dem Addierer Gleichsignal-unterdrückte Signalzüge und Korrekturwerte, welche an den zweiten Split-Signalzügen ermittelt sind, addiert werden. Es können so systematische Fehler im Gleichsignal-unterdrückten Signalzug durch vorzeichenrichtige Addition der Korrekturwerte eliminiert werden.

Bei einer alternativen Ausführungsform ist der Splitter dem Addierer nachgeschaltet, wobei der Addierer Gleichsignal-unterdrückte Signalzüge und Korrekturwerte addiert und der Splitter aus resultierenden Signalzügen erste Split-Signalzüge und zweite Split-Signalzüge abzweigt und die ersten Split-Signalzüge korrigierte Ergebnis-Signalzüge sind. Es lässt sich so ein Regelkreis realisieren. Durch den Regelkreis können zusätzlich aufbaubedingte Offsetfehler reduziert werden. Es wird eine zusätzliche Hochpassfilterwirkung durch Rückkopplung erreicht.

Die Rückgewinnungseinrichtung umfasst einen Tiefpassfilter und/oder Integrator, welcher Korrekturwerte bereitstellt. Dadurch kann eine Angleichung in verschiedenen Signalpfaden insbesondere bezüglich Einschwingverhalten und Frequenzverhalten erreicht werden. Es wird eine Signalglättung für einen Korrekturwert erreicht.

Dem Tiefpassfilter und/oder Integrator sind Signale über einen Einweggleichrichter und/oder Schalter und/oder Komparator bereitgestellt, welcher eine polaritätsabhängige Funktion in Bezug auf die Referenz bereitstellen. Dadurch lässt sich gewissermaßen durch einen Vorzeichenvergleich in einem bestimmten Signalanteil ein Korrekturwert bestimmen.

Bei einer Ausführungsform ist ein Schalter vorgesehen, welcher signalwirksam mit dem Tiefpassfilter und/oder Integrator verbunden ist, und welcher über einen Komparator angesteuert ist, wobei der Komparator Gleichsignal-unterdrückte Signalzüge mit der Referenz vergleicht. Dadurch lässt sich auf einfache Weise ermitteln, ob Signalanteile vorhanden sind, welche eine entgegengesetzte Polarität zur unipolaren Auslenkung haben, und diese Signalanteile können zur Ermittlung der Korrekturwerte genutzt werden.

Bei einem Ausführungsbeispiel ist ein Regelkreis mit einem Splitter vorgesehen, welcher aus Ausgangs-Signalzügen des Addierers erste Split-Signalzüge und zweite Split-Signalzüge abzweigt, wobei aus den zweiten Split-Signalzügen Korrekturwerte bestimmt sind und die ersten Split-Signalzüge die korrigierten Ergebnis-Signalzüge sind. Durch einen Regelkreis können beispielsweise zusätzliche aufbaubedingte Offsetfehler verringert werden.

Beispielsweise ist an der Rückgewinnungseinrichtung ein Komparator angeordnet, welcher zweite Split-Signalzüge mit der Referenz vergleicht. Es lässt sich dadurch eine Rückkopplung erreichen und es ist eine polaritätsabhängige Funktion realisiert.

Der Komparator steuert dann insbesondere einen Schalter und/oder einen Tiefpassfilter (wie einen SC-Tiefpassfilter) und/oder einen Integrator an.

Bei einer Ausführungsform ist zwischen dem Komparator und dem Tiefpassfilter ein ODER-Glied angeordnet, welches mit Steuersignalen angesteuert ist, welche synchron zu den Start-Signalzügen und/oder dem ersten Anteil der Start-Signalzüge sind. An dem ODER-Glied wird eine Verknüpfung mit Ausgangssignalen des Komparators durchgeführt. Durch das Vorsehen eines ODER-Glieds kann beispielsweise erreicht werden, dass auch in Fällen, in denen der Start-Signalzug bzw. der Gleichsignal-unterdrückte Signalzug so niedrige Signale aufweist, dass ein Komparatorschwellenwert noch nicht überschritten wird, trotzdem immer eine rechtzeitige Deaktivierung des Tiefpassfilters bzw. einen Integrators stattfindet.

Bei einem Ausführungsbeispiel insbesondere einer optoelektronischen Vorrichtung ist eine Sendevorrichtung vorgesehen, welche periodische Pulse und insbesondere periodisch gepulste Lichtsignale bereitstellt, und es ist insbesondere eine Empfangseinheit vorgesehen, welche korreliert zu der Sendeeinheit Start-Signalzüge bereitstellt. Die Start-Signalzüge der Empfangseinheit sind elektronische Signale. In diesen elektronischen Signalen korreliert der erste Anteil direkt mit den periodischen Pulsen der Sendeeinrichtung. Der zweite Anteil ist ein Störanteil. Durch das erfindungsgemäße Verfahren und durch die erfindungsgemäße Vorrichtung lässt sich der zweite Anteil minimieren und die korrigierten Ergebnis-Signalzüge enthalten im Wesentlichen nur noch den ersten Anteil.

Die erfindungsgemäße Mess- oder Prüfvorrichtung lässt sich verwenden zur Durchführung des erfindungsgemäßen Verfahrens.

Die nachfolgende Beschreibung bevorzugter Ausführungsformen dient im Zusammenhang mit der Zeichnung der näheren Erläuterung der Erfindung. Es zeigen:
- Figur 1: eine schematische Blockschaltbilddarstellung eines Ausführungsbeispiels einer optischen Sensorvorrichtung;
- Figur 2(a) bis (c): mögliche Signalverläufe bei der optischen Sensorvorrichtung gemäß Figur 1;
- Figur 3: eine schematische Blockschaltbilddarstellung eines Ausführungsbeispiels einer Signalbearbeitungseinrichtung;
- Figur 4(a) bis (e): verschiedene Stufen bei der Signalbearbeitung;
- Figur 5: eine schematische Blockschaltbilddarstellung eines ersten Ausführungsbeispiels einer erfindungsgemäßen Signalbearbeitungseinrichtung;
- Figur 6: eine schematische Blockschaltbilddarstellung eines zweiten Ausführungsbeispiels einer erfindungsgemäßen Signalbearbeitungseinrichtung;
- Figur 7: eine schematische Blockschaltbilddarstellung eines dritten Ausführungsbeispiels einer erfindungsgemäßen Signalbearbeitungseinrichtung;
- Figur 8: eine schematische Blockschaltbilddarstellung eines vierten Ausführungsbeispiels einer erfindungsgemäßen Signalbearbeitungseinrichtung;
- Figur 9: eine schematische Blockschaltbilddarstellung eines fünften Ausführungsbeispiels einer erfindungsgemäßen Signalbearbeitungseinrichtung; und
- Figur 10: eine schematische Blockschaltbilddarstellung eines sechsten Ausführungsbeispiels einer erfindungsgemäßen Signalbearbeitungseinrichtung.

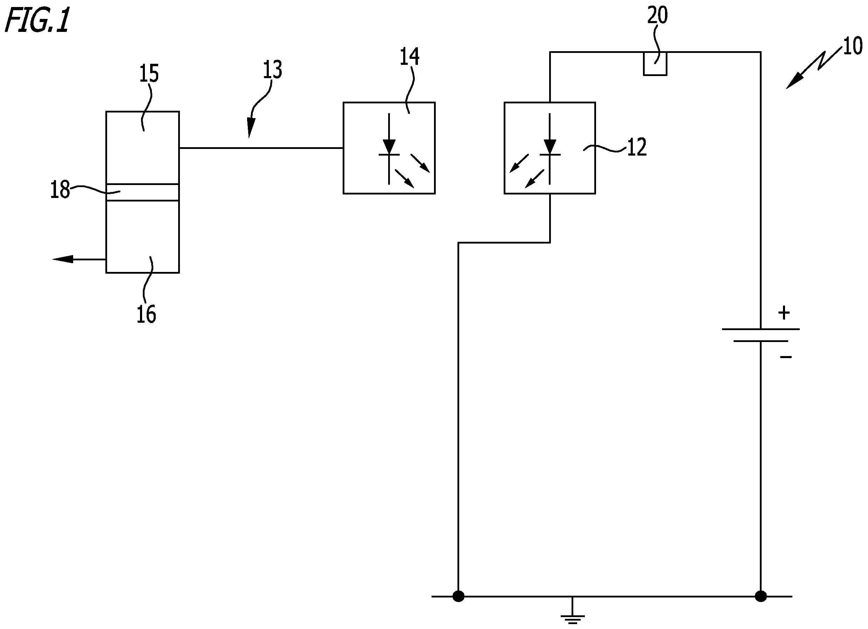

Ein Ausführungsbeispiel einer optischen (optoelektronischen) Sensorvorrichtung als Beispiel einer Messvorrichtung bzw. Prüfvorrichtung, welches in Figur 1 schematisch gezeigt und dort mit 10 bezeichnet ist, umfasst eine optische Sendeeinheit 12, durch welche Licht emittierbar ist. Die optische Sendeeinheit 12 weist eine oder mehrere Lichtquellen beispielsweise in Form einer oder mehrerer Leuchtdioden oder eines oder mehrerer Laser auf.

Der optischen Sendeeinheit 12 ist in einem Empfängerpfad 13 eine Empfangseinheit 14 zugeordnet. Diese ist beabstandet zu der optischen Sendeeinheit 12. Durch sie ist von der optischen Sendeeinheit 12 emittiertes Licht empfangbar und detektierbar. Die Empfangseinheit steht in Verbindung mit einer Verstärkungseinrichtung 15 und einer Auswertungseinrichtung 16, welche die empfangenen Signale auswertet.

Es ist eine Signalbearbeitungseinrichtung 18 vorgesehen, welche die von der Empfangseinheit 14 bereitgestellten Signale bearbeitet. Diese bereitgestellten Signale sind elektronische Signale. Die Signalbearbeitungseinrichtung 18 ist insbesondere Teil der Auswertungseinrichtung 16.

Es ist beispielsweise vorgesehen, dass die optische Sendeeinheit 12 und die Empfangseinheit 14 direkt aufeinander ausgerichtet sind und die Empfangseinheit 14 von der optischen Sendeeinheit 12 direkt bestrahlt wird. Es ist dann beispielsweise detektierbar, ob ein Gegenstand im Strahlengang zwischen der optischen Sendeeinheit 12 und der Empfangseinheit 14 vorhanden ist.

Es ist beispielsweise auch möglich, dass die optische Sendeeinheit 12 als Reflexionslichtschranke ausgebildet ist, wobei dann von der optischen Sendeeinheit 12 ausgesandtes Licht an einem Reflektor reflektiert wird und reflektiertes Licht durch die Empfangseinheit 14 empfanden wird.

Ausführungsbeispiele für die optische Sensorvorrichtung 10 sind Lichttaster, Reflexionslichtschranken, Einweglichtschranken usw.

Es ist eine als Ganzes mit 20 bezeichnete Ansteuerungseinrichtung für die optische Sendeeinheit 12 vorgesehen. Die Ansteuerungseinrichtung 20 stellt einen definierten Ansteuerungsstrom der Sendeeinheit 12 zur gesteuerten Lichtemission bereit. Die Ansteuerungseinrichtung 20 steuert dabei insbesondere die optische Sendeeinheit 12 so an, dass periodische Lichtpulse ausgesandt werden.

Beispielsweise haben die Lichtpulse eine Rechteckform oder Trapezform oder Dreiecksform.

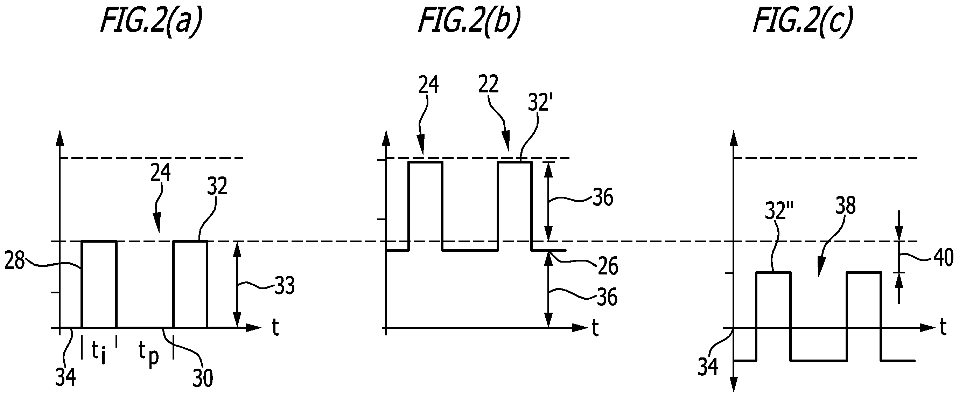

Bei einem Ausführungsbeispiel stellt die Sendeeinheit 12 periodische Pulse bereit. Die Empfangseinheit 14 empfängt die Pulse und stellt dann einen Start-Signalzug 22 (Figur 2(b)) zur weiteren Auswertung bereit. Dieser elektronische Start-Signalzug 22 umfasst einen ersten Anteil 24 und einen zweiten Anteil 26. Der erste Anteil 24 (vergleiche Figur 2(a)) umfasst periodische Pulse 28 mit Pulszeiten tᵢ und Pausenzeiten tₚ zwischen benachbarten Pulsen 28. Die Pulse 28 weisen einen Minimalwert 30 und einen Maximalwert oder Scheitelwert 32 auf. Sie haben eine Höhe 33 als Differenz zwischen Maximalwert 32 und Minimalwert 30. Der Minimalwert 30 liegt bei einer Referenz 34. Bei dem in Figur 2(a) gezeigten Ausführungsbeispiel ist die Referenz 34 ein Referenzwert, welcher ein Nullwert ist.

Die Pulse 28 haben beispielsweise eine Rechteck-, Trapez- oder Dreiecksform.

Der erste Anteil 24 des Start-Signalzugs 22 der Empfangseinheit 14 steht in direkter Korrelation mit den Sendepulsen der Sendeeinheit 12. Insbesondere weisen die Pulse 28 im Wesentlichen die gleiche Form wie die Sendepulse der Sendeeinheit 12 auf.

Zwischen der Sendeeinheit 12 und der Empfangseinheit 14 können Störsignale auftreten wie beispielsweise Streulicht (beispielsweise aufgrund Sonnenlicht) bei einer optischen Sensorvorrichtung 10. Auch Offset-Spannungen im Empfängerpfad 13 können zu diesem zweiten Anteil 26 beitragen. Der zweite Anteil 26 ist ein Gleichanteil, welcher dem ersten Anteil 24 überlagert ist. Durch den zweiten Anteil 26 wird der Maximalwert im Start-Signalzug 22 im Vergleich zu dem Maximalwert 32 im ersten Anteil 24 nach oben verschoben. Ein Maximalwert 32' in dem Start-Signalzug 22 gemäß Figur 2(b) ist um einen Fehlerbetrag 36 höher als der Maximalwert 32 im ersten Anteil 24. Der Fehlerbetrag 36 entspricht gerade dem zweiten Anteil 26 als Gleichanteil.

Bei einer Nutzung des Start-Signalzugs 22, welche auf Maximalwerten gegenüber der Referenz 34 basiert, entsteht eben ein Fehler mit dem Fehlerbetrag 36.

Grundsätzlich kann an dem Start-Signalzug 22 eine Gleichsignalunterdrückung durchgeführt werden, um dem Start-Signalzug um den zweiten Anteil 26 zu korrigieren. Es wird dadurch ein Gleichsignal-unterdrückter Signalzug 38 hergestellt (Figur 2(c)). Ein solcher Gleichsignal-unterdrückter Signalzug 38 kann durch Gleichsignalunterdrückung bzw. Wechselsignalankopplung entstehen. Ein Ziel sollte dabei sein, den Fehlerbetrag 36 zu kompensieren.

Jedoch enthält auch der erste Anteil 24 einen Gleichanteil, welcher insbesondere der Mittelwert über Pulszeiten tᵢ und Pausenzeiten tₚ gemittelt ist. Bei einer entsprechenden Gleichsignalunterdrückung bzw. Wechselsignalankopplung wird zwangsläufig dieser Gleichanteil im ersten Anteil 24 erfasst. Der Gleichsignal-unterdrückte Signalzug 38 wird bei der Gleichsignalunterdrückung gewissermaßen überkompensiert. Dies ist in Figur 2(c) angedeutet. Der Gleichsignal-unterdrückte Signalzug 38 ist gegenüber der Referenz 34 nach unten verschoben, wobei ein Abstand 40 der resultierende Fehler ist.

Bei einer Nutzung des Gleichsignal-unterdrückten Signalzugs 38 über den Abstand eines Maximalwerts 32" zu der Referenz 34 ist der Abstand 40 (welcher der Abstand ist zwischen dem Maximalwert 32" und dem Maximalwert 32) der durch die Gleichsignalunterdrückung erzeugte Fehler.

Erfindungsgemäß werden ein Verfahren und eine Vorrichtung zur Elimination des Abstands 40 bereitgestellt.

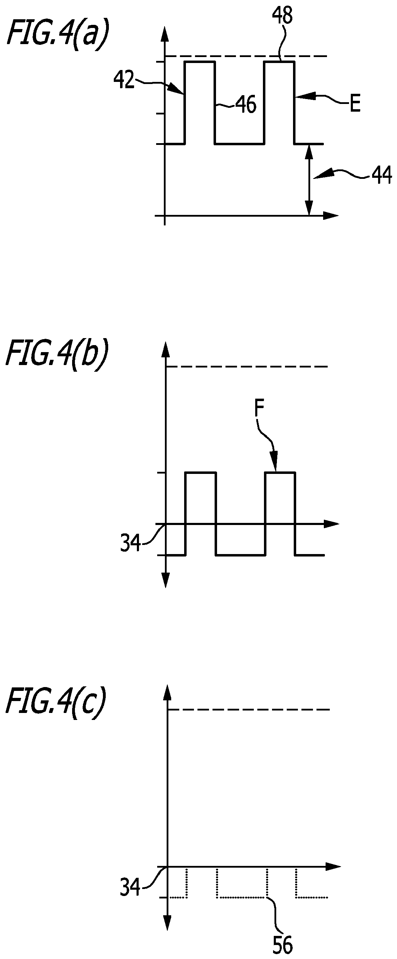

Bei der erfindungsgemäßen Lösung wird ein Start-Signalzug E (Figur 4(a)) beispielsweise durch die Empfangseinheit 14 bereitgestellt. Dieser Start-Signalzug E ist beispielsweise ein Signalzug elektronischer Signale. Er umfasst einen ersten Anteil 42 (entsprechend dem ersten Anteil 24) und einen zweiten Anteil 44. Der erste Anteil 42 besteht aus periodischen Pulsen, welche gegenüber einer Referenz 34 (vergleiche Figur 2(a)) unipolar ausgelenkt sind, das heißt einseitig ausgelenkt sind. In Figur 4(a) ist diese einseitige Auslenkung mit dem Bezugszeichen 46 angedeutet. Periodische Pulse 48 in dem ersten Anteil 42 erstrecken sich zwischen einem Minimalwert und einem Maximalwert, wobei der Minimalwert bei der Referenz 34 liegt.

Der zweite Anteil 44 ist ein Gleichanteil, welcher beispielsweise durch eine externe Störung und/oder Offset-Spannungen verursacht wird.

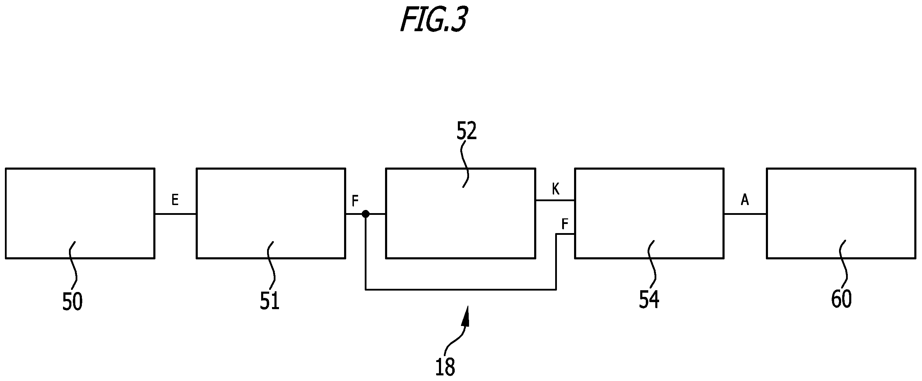

Wie in Figur 3 schematisch angedeutet, wird der Start-Signalzug 22 durch eine Einheit 50 bereitgestellt, welche beispielsweise die Empfangseinheit 14 ist.

Der Start-Signalzug E wird einer Gleichsignalunterdrückungseinrichtung 51 bereitgestellt. Diese erzeugt einen Gleichsignal-unterdrückten Signalzug F (Figur 4(b)). Der Gleichsignal-unterdrückte Signalzug F wird insbesondere durch Gleichsignalunterdrückung (Filterung) oder Wechselsignalankopplung erzeugt.

Der Gleichsignal-unterdrückte Signalzug F gemäß Figur 4(b) entspricht vom Prinzip her dem Gleichsignal-unterdrückten Signalzug 38 gemäß Figur 2(c). Der Gleichsignal-unterdrückte Signalzug F ist fehlerbehaftet; er ist bezüglich der Referenz 34 bipolar oder zumindest nicht mehr unipolar, das heißt er weist bezüglich der Referenz 34 Anteile unterhalb der Referenz 34 auf.

Der Gleichsignal-unterdrückte Signalzug F wird einer Rückgewinnungseinrichtung 52 (Figur 3) bereitgestellt. Die Rückgewinnungseinrichtung 52 generiert aus dem Gleichsignal-unterdrückten Signalzug F einen Korrekturwert K (beispielsweise in der Form von Korrektursignalen), welcher in einem Addierer 54 zu dem Gleichsignal-unterdrückten Signalzug F addiert wird.

Der Korrekturwert K ist insbesondere ein Gleichwert (welcher sich jedoch mit der Zeit grundsätzlich "langsam" gegenüber einer Pulsperiode ändern kann).

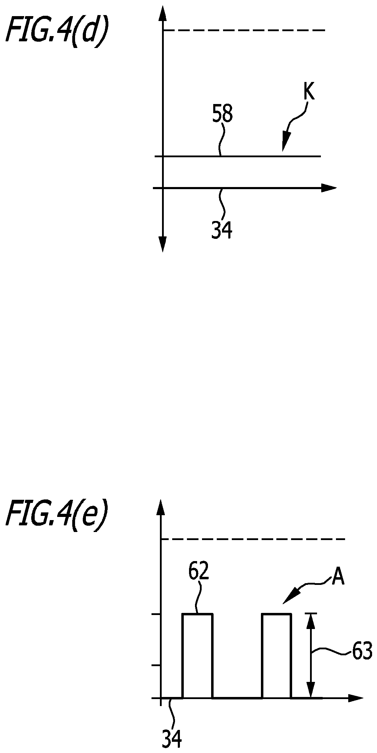

In Figur 4(c) ist ein Signalanteil 56 gezeigt, welcher dem Signalanteil des Signalzugs F gemäß Figur 4(b) entspricht, welcher unterhalb der Referenz 34 liegt, das heißt welcher eine entgegengesetzte Polarität zu der unipolaren (einseitigen) Auslenkung 46 im ersten Anteil 42 aufweist. Der Signalanteil 56 wird an der Rückgewinnungseinrichtung 52 erzeugt. Durch Tiefpassfilterung bzw. Integration wird aus dem Signalanteil 56 ein entsprechender Gleichanteil 58 und damit der Korrekturwert K erzeugt (siehe Figur 4(d)).

Bei der Darstellung gemäß Figur 4(d) ist der Korrekturwert K unipolar bezüglich der Referenz 34. Es hat eine Invertierung stattgefunden. Dieser Korrekturwert K wird nach der Invertierung in dem Addierer 54 zu dem Gleichsignal-unterdrückten Signalzug F addiert. Durch die Invertierung ist diese Addition vorzeichenrichtig. Es entsteht dann der korrigierte Ergebnis-Signalzug A gemäß Figur 4(e) als A = F + K. Der Ergebnis-Signalzug hat eine Signalhöhe 63.

Durch die Addition des rückgewonnenen Korrekturfaktors K (aus dem Gleichsignal-unterdrückten Signalzug F) wird der Abstand 40 kompensiert. Der korrigierte Ergebnis-Signalzug A entspricht dem ersten Anteil 42 (vergleiche auch Figur 2(a)), wobei der durch die Gleichsignalunterdrückungseinrichtung 51 verursachte Fehler, welcher dem Abstand 40 entspricht und auf den Gleichanteil in dem ersten Anteil 42 zurückzuführen ist, durch vorzeichenrichtige Addition des Korrekturwerts K kompensiert wurde.

Der korrigierte Ergebnis-Signalzug A ist dann direkt nutzbar, welches in Figur 3 durch das Bezugszeichen 60 angedeutet ist. Bei einer Nutzung bezüglich eines Maximalwerts 62 zu der Referenz 34 ist der Abstand 40 eliminiert.

Ein Abstand eines Scheitelwerts (Maximalwert 62) in dem korrigierten Ergebnis-Signalzug A zu der Referenz 34 (Signalhöhe 63) entspricht dem Abstand in dem ersten Anteil 42 zwischen dem entsprechenden Maximalwert 32 dort und dem Minimalwert 30 wie der Referenz 34 (Signalhöhe 33). Dieser Abstand 63 ist dabei insbesondere größer als der Abstand zwischen dem Scheitelwert in dem Gleichsignal-unterdrückten Signalzug 38 und der Referenz 34 (Figur 4(b)).

Durch die Rückgewinnungseinrichtung 52 wird über eine polaritätsabhängige Funktion aus dem Gleichsignal-unterdrückten Signalzug 38 der Korrekturwert K erzeugt, über welchen der Abstand 40 eliminierbar ist.

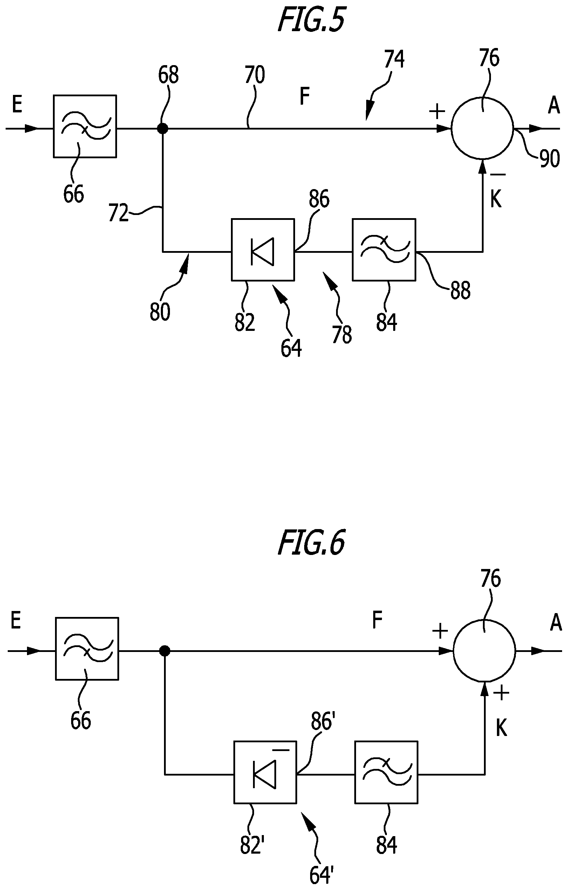

Bei einem ersten Ausführungsbeispiel einer erfindungsgemäßen Signalbearbeitungseinrichtung 64 (Figur 5) ist als Gleichsignalunterdrückungseinrichtung 51 ein Hochpassfilter 66 vorgesehen. Dieser Hochpassfilter 66 erzeugt aus dem Start-Signalzug E den Gleichsignal-unterdrückten Signalzug F.

Dem Hochpassfilter 66 ist ein Splitter 68 nachgeschaltet. Dieser Splitter (Signalverzweiger) spaltet den Gleichsignal-unterdrückten Signalzug F, welcher von dem Hochpassfilter 66 bereitgestellt ist, auf in einen ersten Split-Signalzug 70 und einen zweiten Split-Signalzug 72. Der erste Split-Signalzug und der zweite Split-Signalzug entsprechen dabei dem Gleichsignal-unterdrückten Signalzug F.

In einem ersten Pfad 74 für den ersten Split-Signalzug 70 ist ein Addierer 76 angeordnet, welcher dem Addierer 54 entspricht. Diesem Addierer 76 wird der erste Split-Signalzug 70 an einem Eingang bereitgestellt.

Eine Rückgewinnungseinrichtung 78 ist an einem zweiten Pfad 80 für den zweiten Split-Signalzug 72 angeordnet.

Bei dem Ausführungsbeispiel gemäß Figur 5 umfasst die Rückgewinnungseinrichtung 78 einen Einweggleichrichter 82, welchem ein Tiefpassfilter 84 nachgeschaltet ist.

Bei diesem Ausführungsbeispiel ist die Referenz 34 insbesondere ein Nullwert bzw. ein Massepotential. Der Einweggleichrichter 82 lässt in dem zweiten Split-Signalzug 72 zur Bereitstellung der polaritätsabhängigen Funktion nur die negativen Spannungspulse bzw. Strompulse durch. Dies sind die Impulse, welche bezüglich der unipolaren Auslenkung in dem ersten Anteil 42 eine entgegengesetzte Polarität aufweisen. Ein an einem Ausgang 86 des Einweggleichrichters 82 anstehender Signalzug hat dann die in Figur 4(c) gezeigte Form. Dieser Signalzug wird dann dem Tiefpassfilter 84 bereitgestellt. Dieser erzeugt ein Gleichsignal, wobei auch Restwelligkeiten und Rauschen reduziert werden. Es wird ferner dadurch das Frequenzverhalten bzw. das Einschwingverhalten des ersten Pfads 74 und des zweiten Pfads 80 angeglichen.

Das an einem Ausgang 88 des Tiefpassfilters 84 anstehende Signal ist prinzipiell der Korrekturwert K, welcher dem Addierer 76 zugeführt wird und es verfolgt eine vorzeichenrichtige Addition.

Bei dem in Figur 5 gezeigten Ausführungsbeispiel weist das am Ausgang 88 des Tiefpassfilters 84 bereitstehende Signal eine entgegengesetzte Polarität zu der einseitigen Auslenkung in dem ersten Anteil 42 auf. An dem Addierer 76 erfolgt zur Realisierung der Vorzeichenrichtigkeit eine Subtraktion, um den Abstand 40 zu eliminieren.

An einem Ausgang 90 des Addierers 76 ist dann der korrigierte Ergebnis-Signalzug A bereitgestellt.

Bei einer Variante der Signalbearbeitungseinrichtung, welche in Figur 6 schematisch gezeigt und dort mit 64' bezeichnet ist, ist der Aufbau grundsätzlich gleich wie bei der Signalbearbeitungseinrichtung 64. Es ist ein Einweggleichrichter 82' vorgesehen, welcher invertierend ist. An dessen Ausgang 86' wird ein Signal bereitgestellt, welches im Vergleich zu dem in Figur 4(c) gezeigten Anteil invertiert ist, das heißt bezüglich der Referenz 34 die gleiche Polarität aufweist wie die Pulse im ersten Anteil 42.

Das entsprechende Signal wird durch den Tiefpassfilter 84 durchgeführt. Der so erzeugte Korrekturwert K wird dann vorzeichenrichtig an dem Addierer 76 zu dem ersten Split-Signalzug 70 addiert.

Bei der Signalbearbeitungseinrichtung 64 erfolgt eine Inversion zur Bereitstellung des Korrekturwerts K an dem Addierer 76. Bei der Signalbearbeitungseinrichtung 64' wird die Invertierung an dem Einweggleichrichter 82' durchgeführt.

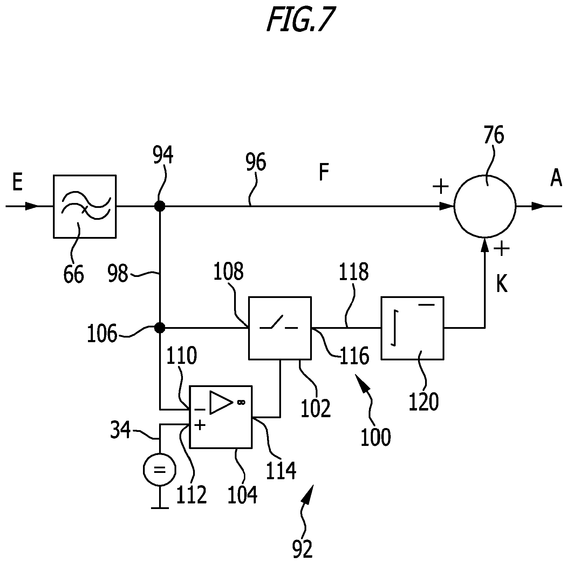

Bei dem Ausführungsbeispiel einer erfindungsgemäßen Signalbearbeitungseinrichtung, welche in Figur 7 gezeigt und dort mit 92 bezeichnet ist, ist wiederum ein Hochpassfilter vorgesehen. Wie bei der Signalbearbeitungseinrichtung 64 bzw. 64' wird das Bezugszeichen 66 verwendet. Diesem Hochpassfilter wird der Start-Signalzug E bereitgestellt und der Hochpassfilter erzeugt den Gleichsignal-unterdrückten Signalzug F.

Dem Hochpassfilter 66 ist ein Splitter 94 bereitgestellt, welcher aus dem Gleichsignal-unterdrückten Signalzug F in einem ersten Pfad 96 einen ersten Split-Signalzug und in einem zweiten Pfad 98 einen zweiten Split-Signalzug erzeugt. Der erste Split-Signalzug und der zweite Split-Signalzug sind identisch zueinander und entsprechen dem Gleichsignal-unterdrückten Signalzug F.

Ein Addierer entsprechend dem Addierer 76 (es wird deshalb auch das gleiche Bezugszeichen verwendet) ist dem Splitter 94 nachgeschaltet in dem ersten Pfad 96 angeordnet. Einem Eingang des Addierers 76 wird der erste Split-Signalzug bereitgestellt.

In dem zweiten Pfad 98 ist eine Rückgewinnungseinrichtung 100 angeordnet. Die Rückgewinnungseinrichtung 100 umfasst einen Schalter 102 und einen Komparator 104. Der Komparator 104 steuert den Schalter 102 an.

In dem zweiten Pfad 98 ist eine Verzweigung 106 angeordnet. Die Verzweigung 106 stellt den zweiten Split-Signalzug einem Eingang 108 des Schalters 102 bereit. Ferner wird der zweite Split-Signalzug einem ersten Eingang 110 des Komparators 104 bereitgestellt.

Einem zweiten Eingang 112 des Komparators 104 wird die Referenz 34 bereitgestellt. Der Komparator 104 vergleicht den zweiten Split-Signalzug mit der Referenz 34.

Ein Ausgang 114 des Komparators 104 ist signalwirksam mit dem Schalter 102 verbunden.

Ein Ausgang 116 des Schalters 102 ist über einen Signalweg 118 signalwirksam mit einem Integrator 120 verbunden.

Bei dem in Figur 7 gezeigten Ausführungsbeispiel ist der Integrator 120 ein invertierender Integrator.

Der über die Verzweigung 106 aufgeteilte zweite Split-Signalzug wird mit der Referenz 34 verglichen. Der Komparator 104 stellt ein Ausgangssignal 114 bereit, welches den Schalter 102 ansteuert und je nach dem Ausgangssignal, welches am Ausgang 114 des Komparators 104 ansteht, wird der Signalweg 118 unterbrochen oder freigegeben.

Wenn der zweite Split-Signalzug einen Anteil aufweist, welcher sich unterhalb der Referenz 34 befindet (das heißt eine zu der unipolaren Auslenkung im ersten Anteil 42 entgegengesetzte Polarität aufweist), dann wird dem Schalter 102 ein Schaltsignal bereitgestellt. Der entsprechende Anteil des zweiten Split-Signalzugs wird dann dem Integrator 120 bereitgestellt. Dieser Anteil entspricht dem in Figur 4(c) gezeigten Signalanteil.

Für Signalanteile mit einer Auslenkung in Richtung der unipolaren Auslenkung des ersten Anteils 42 im Start-Signalzug E liefert der Komparator 104 ein Unterbrechungssignal und der Signalweg 118 ist nicht geschaltet.

Der Integrator 120 erzeugt dann ein Gleichsignal, wobei er bei dem Ausführungsbeispiel gemäß Figur 7 eine Invertierung durchführt.

Es wird dadurch der Korrekturwert K erzeugt, welcher an dem Addierer 76 vorzeichenrichtig addiert wird (mit positivem Vorzeichen). An dem Addierer 76 ist dann der korrigierte Ergebnis-Signalzug A abgreifbar.

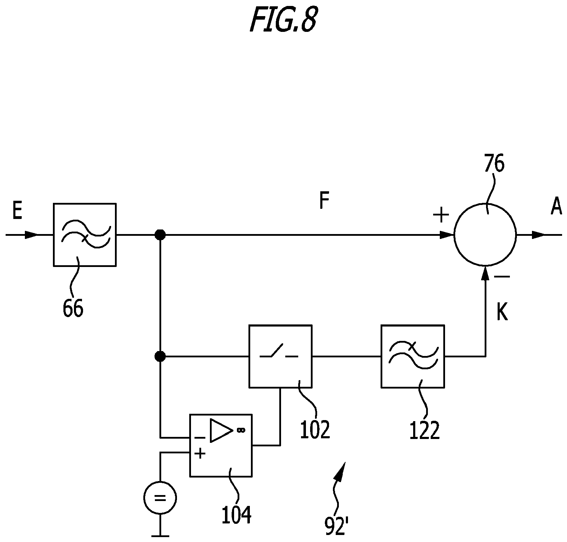

Bei einer Variante der Signalbearbeitungseinrichtung, welche in Figur 8 schematisch gezeigt und dort mit 92' bezeichnet ist, ist der Aufbau grundsätzlich gleich wie in Figur 7, wobei anstatt des Integrators 120 mit Invertierungsfunktion ein Tiefpassfilter 122 ohne Invertierungsfunktion vorgesehen ist.

Die Invertierung zur vorzeichenrichtigen Addierung des Korrekturwerts K zum Gleichsignal-unterdrückten Signalzug F wird an dem Addierer 76 durchgeführt.

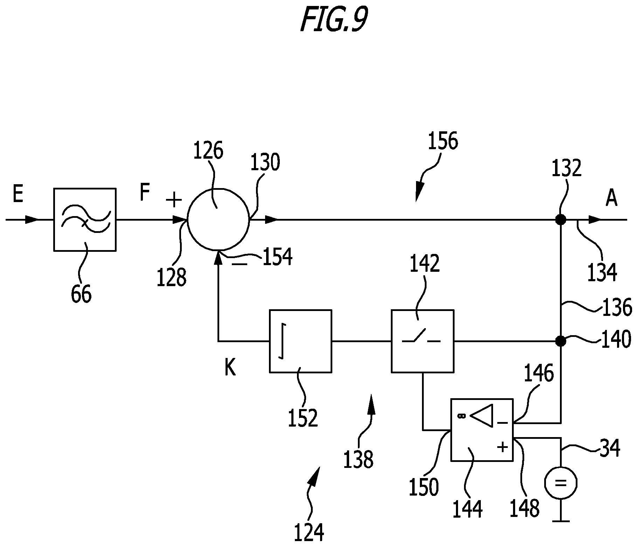

Bei einem weiteren Ausführungsbeispiel einer Signalbearbeitungseinrichtung, welche in einem Blockschaltbild in Figur 9 gezeigt und dort mit 124 bezeichnet ist, wird der Start-Signalzug E wiederum einem Hochpassfilter 66 zur Erzeugung des Gleichsignal-unterdrückten Signalzugs F bereitgestellt.

Dem Hochpassfilter 66 ist ein Addierer 126 nachgeschaltet. Der Gleichsignal-unterdrückte Signalzug F wird einem ersten Eingang 128 des Addierers 126 bereitgestellt.

Der Addierer 126 weist einen Ausgang 130 auf, an welchem ein Signalzug bereitgestellt ist. Dieser Ausgang 130 ist signalwirksam mit einem Splitter 132 verbunden. Der Splitter 132 erzeugt in einem ersten Pfad 134 einen ersten Split-Signalzug und in einem zweiten Pfad 136 einen zweiten Split-Signalzug. Der erste Split-Signalzug ist der korrigierte Ergebnis-Signalzug A.

Im zweiten Pfad 136 liegt eine Rückgewinnungseinrichtung 138. Die Rückgewinnungseinrichtung 138 umfasst eine Verzweigung 140, welche signalwirksam mit dem Splitter 132 verbunden ist. An die Verzweigung 140 ist signalwirksam ein Schalter 142 angeschlossen. Ferner ist an die Verzweigung 140 signalwirksam ein Komparator 144 über einen ersten Eingang 146 angeschlossen. Die Verzweigung 140 erzeugt aus dem zweiten Split-Signalzug einen Signalzug, welcher dem Schalter 142 zugeführt wird, und einen identischen Signalzug, welcher dem ersten Eingang 146 des Komparators 144 zugeführt wird.

Der Komparator weist ferner einen zweiten Eingang 148 auf, an welchem die Referenz 34 anliegt bzw. ansteht. Beispielsweise liegt der zweite Eingang 148 an einem Massepotential bzw. ein Referenzsignal wird an dem zweiten Eingang 148 eingekoppelt.

Der Komparator 144 steuert über einen Ausgang 150 den Schalter 142 an.

Der Schalter 142 wiederum steuert einen Integrator 152 an. Der Integrator stellt den Korrekturwert K bereit, welcher über einen zweiten Eingang 154 dem Addierer 126 zugeführt wird.

Bei dem in Figur 9 gezeigten Ausführungsbeispiel erfolgt an dem zweiten Eingang 154 eine Invertierung zur vorzeichenrichtigen Addierung.

Der Schalter 142 stellt über eine polaritätsabhängige Funktion dem Integrator 152 einen Signalanteil bereit, wobei die polaritätsabhängige Funktion über den Komparator 144 realisiert ist. Wenn eine Spannung bzw. ein Strom unterhalb der Referenz 34 liegt, dann ist der Schalter 142 geschaltet, das heißt der zweite Split-Signalzug wird dem Integrator 152 bereitgestellt, wo eine Integration stattfindet, um den Korrekturwert K zu erzeugen. Wenn ein Anteil des zweiten Split-Signalzugs oberhalb der Referenz 34 liegt (mit gleicher Auslenkungsrichtung wie die unipolare Auslenkung in dem ersten Anteil 42), dann ist der Schalter 142 durch den Komparator 144 so angesteuert, dass er nicht schaltend ist.

Bei der Signalbearbeitungseinrichtung 124 ist der Splitter 132 dem Addierer 126 nachgeschaltet. Es ist dadurch ein Regelkreis 156 gebildet. Der Korrekturwert K wird aus einem Ausgangssignal des Addierers 126 erzeugt. Es liegt dadurch eine Rückkopplung an dem Addierer 126 vor.

Durch den Regelkreis 156 können zusätzliche Offset-Fehler, die beispielsweise aufbaubedingt sind, reduziert werden. Es wird weiterhin eine zusätzliche

Hochpassfilterwirkung an einem Ausgang aufgrund des rückgekoppelten, tiefpassgefilterten Signals erreicht.

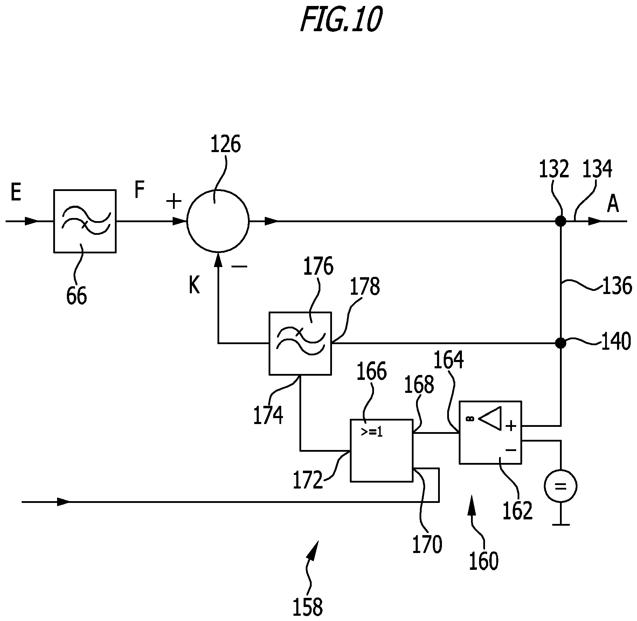

Bei einem weiteren Ausführungsbeispiel einer Signalbearbeitungseinrichtung, welche in Figur 10 schematisch gezeigt und dort mit 158 bezeichnet ist, ist wiederum ein Hochpassfilter 66 vorgesehen, welchem ein Addierer 126 nachgeschaltet ist. Dem Addierer 126 ist ein Splitter 132 nachgeschaltet.

Es ist ein erster Pfad 134 und es ist ein zweiter Pfad 136 vorgesehen wie bei der Signalbearbeitungseinrichtung 124 (es werden deshalb auch gleiche Bezugszeichen verwendet), wobei in dem zweiten Pfad eine Rückgewinnungseinrichtung 160 angeordnet ist. Die Rückgewinnungseinrichtung 160 umfasst einen Komparator 162, welcher bezüglich seiner Eingänge auf die gleiche Weise wie der Komparator 144 angesteuert ist.

Ein Ausgang 164 des Komparators 162 ist signalwirksam mit einem ODER-Glied 166 verbunden. Ausgangssignale des Komparators 162 werden einem ersten Eingang 168 des ODER-Glieds 166 bereitgestellt. Einem zweiten Eingang 170 des ODER-Glieds 166 werden Steuersignale bereitgestellt. Die Steuersignale sind dabei synchron zu dem Start-Signalzug E bzw. dem ersten Anteil 42 des Start-Signalzugs E.

An dem ODER-Glied 166 wird eine ODER-Verknüpfung durchgeführt. Ein Ausgang 172 des ODER-Glieds 166 steht in signalwirksamer Verbindung mit einem ersten Eingang 174 eines Tiefpassfilters 176.

In dem zweiten Pfad 136 ist wie bei der Signalbearbeitungseinrichtung 124 eine Verzweigung 140 angeordnet. Diese Verzweigung 140 stellt dem Tiefpassfilter 176 den zweiten Split-Signalzug an einem zweiten Eingang 178 bereit.

Der Komparator 162 funktioniert grundsätzlich gleich wie der Komparator 144; er stellt eine polaritätsabhängige Funktion bereit, um die Anteile im zweiten Split-Signalzug mit entgegengesetzter Polarität zur unipolaren Auslenkung im ersten Anteil 42 zu gewinnen.

An dem ODER-Glied 166 folgt eine ODER-Verknüpfung zwischen dem Ausgang 164 des Komparators 162 und Steuersignalen.

Im Beispielsfall einer optischen Sensorvorrichtung 10 können beispielsweise Steuersignale von einer Pulsphase von Sendepulsen der Sendeeinheit 12 abgeleitet werden.

Durch das zwischengeschaltete ODER-Glied 166 wird eine weitere Verbesserung der Fehlerkorrektur erreicht. Es kann eine Fehl-Filterung und/oder Fehl-Integration des Gleichsignal-unterdrückten Signalzugs F bis zum Durchschreiten eines Schwellenwerts des Komparators 162 unterdrückt werden. Eine Weiterleitungsfunktion hat dadurch eine größere Unabhängigkeit gegenüber einer Eingangssignalamplitude. Es kann dann der KomparatorSchwellenwert zur Erhöhung der Störsicherheit gegenüber Rauschen und Störsignalen für den Gleichsignal-unterdrückten Signalzug F erhöht werden. Es kann sichergestellt werden, dass immer eine rechtzeitige Deaktivierung der Tiefpassfilterungsfunktion bzw. einer Integratorfunktion erfolgt, wenn anstatt eines Tiefpassfilters 176 ein Integrator vorgesehen ist, wobei auch Fälle erfasst werden, bei denen der Scheitelwert im Start-Signalzug E oder im Gleichsignal-unterdrückten Signalzug so niedrig ist, dass der Komparatorschwellenwert noch nicht überschritten ist.

Erfindungsgemäß werden ein Verfahren und eine Vorrichtung bereitgestellt, bei denen aus einem Start-Signalzug E, welcher als zweiten Anteil einen Gleichanteil umfasst, nach Gleichsignalunterdrückung ein resultierender Fehler, welcher dem Abstand 40 entspricht, eliminiert werden kann. Dazu wird über eine polaritätsabhängige Funktion, welche beispielsweise durch den Einweggleichrichter 82 bzw. 82' realisiert wird, oder durch die Komparatoren 104, 144, 162 realisiert wird, ein Korrekturwert K zur Fehlerkorrektur ermittelt. Der Korrekturwert K wird vorzeichenrichtig zum Gleichsignal-unterdrückten Signalzug F addiert und der daraus resultierende korrigierte Ergebnis-Signalzug A ist fehlerreduziert.

Die polaritätsabhängige Funktion ist auf die Referenz 34 bezogen. Über die polaritätsabhängige Funktion wird erkannt, wenn Signalanteile eine Auslenkung mit entgegengesetzter Polarität bezogen auf die Referenz 34 im Vergleich zu der einseitigen Auslenkung 46 haben.

Es lässt sich so eine fehlerarme Schwingungsbreiten-Bestimmung realisieren. Der durch die Gleichsignalunterdrückung grundsätzlich erzeugte Fehler wird mindestens näherungsweise ausgeglichen.

In den Figuren 2 und 4 wurde die Unipolarität als positive Auslenkung gezeigt. Das erfindungsgemäße Verfahren funktioniert genauso bei unipolarer negativer Auslenkung.

### Bezugszeichenliste

- 10: Optische Sensorvorrichtung
- 12: Sendeeinheit
- 13: Empfängerpfad
- 14: Empfangseinheit
- 15: Verstärkungseinrichtung
- 16: Auswertungseinrichtung
- 18: Signalbearbeitungseinrichtung
- 20: Ansteuerungseinrichtung
- 22: Start-Signalzug
- 24: Erster Anteil
- 26: Zweiter Anteil
- 28: Puls
- 30: Minimalwert
- 32: Maximalwert
- 32': Maximalwert
- 32": Maximalwert
- 33: Höhe
- 34: Referenz
- 36: Fehlerbetrag
- 38: Gleichsignal-unterdrückter Signalzug
- 40: Abstand
- 42: Erster Anteil
- 44: Zweiter Anteil
- 46: Einseitige Auslenkung
- 48: Puls
- 50: Einheit
- 51: Gleichsignalunterdrückungseinrichtung
- 52: Rückgewinnungseinrichtung
- 54: Addierer
- 56: Signalanteil
- 58: Gleichanteil
- 60: Nutzung
- 62: Maximalwert
- 63: Signalhöhe
- 64: Signalbearbeitungseinrichtung
- 64': Signalbearbeitungseinrichtung
- 66: Hochpassfilter
- 68: Splitter
- 70: Erster Split-Signalzug
- 72: Zweiter Split-Signalzug
- 74: Erster Pfad
- 76: Addierer
- 78: Rückgewinnungseinrichtung
- 80: Zweiter Pfad
- 82: Einweg-Gleichrichter
- 82': Einweg-Gleichrichter
- 84: Tiefpassfilter
- 86: Ausgang
- 86': Ausgang
- 88: Ausgang
- 90: Ausgang
- 92: Signalbearbeitungseinrichtung
- 92': Signalbearbeitungseinrichtung
- 94: Splitter
- 96: Erster Pfad
- 98: Zweiter Pfad
- 100: Rückgewinnungseinrichtung
- 102: Schalter
- 104: Komparator
- 106: Verzweigung
- 108: Eingang
- 110: Erster Eingang
- 112: Zweiter Eingang
- 114: Ausgang
- 116: Ausgang
- 118: Signalweg
- 120: Integrator
- 122: Tiefpassfilter
- 124: Signalbearbeitungseinrichtung
- 126: Addierer
- 128: Erster Eingang
- 130: Ausgang
- 132: Splitter
- 134: Erster Pfad
- 136: Zweiter Pfad
- 138: Rückgewinnungseinrichtung
- 140: Verzweigung
- 142: Schalter
- 144: Komparator
- 146: Erster Eingang
- 148: Zweiter Eingang
- 150: Ausgang
- 152: Integrator
- 154: Zweiter Eingang
- 156: Regelkreis
- 158: Signalbearbeitungseinrichtung
- 160: Rückgewinnungseinrichtung
- 162: Komparator
- 164: Ausgang
- 166: ODER-Glied
- 168: Erster Eingang
- 170: Zweiter Eingang
- 172: Ausgang
- 174: Erster Eingang
- 176: Tiefpassfilter
- 178: Zweiter Eingang
- E: Start-Signalzug
- F: Gleichsignal-unterdrückter Signalzug
- K: Korrekturwert
- A: Korrigierter Ergebnis-Signalzug

## Patentansprüche

1. Verfahren zum Bearbeiten eines Start-Signalzugs (E), welcher einen ersten Anteil (42) mit periodischen Pulsen (48) umfasst, wobei die Pulse (48) unipolar zu einer Referenz (34) ausgelenkt sind, und einen zweiten Anteil (44) umfassen kann, welcher ein Störanteil mit Gleichsignalen ist, bei dem aus dem Start-Signalzug (E) ein Gleichsignal-unterdrückter Signalzug (F) erzeugt wird, wobei:
- der Gleichsignal-unterdrückte Signalzug (F) aus dem Start-Signalzug (E) durch Gleichsignalunterdrückung oder Wechselsignalankopplung erzeugt wird, **dadurch gekennzeichnet, dass**
- aus dem Gleichsignal-unterdrückten Signalzug (F) ein Gleichanteil des ersten Anteils (42) des Start-Signalzugs (E) als Korrekturwert (K) ermittelt wird, wobei der Korrekturwert (K) zur Rückgewinnung des Gleichanteils des ersten Anteils (42) des Start-Signalzugs (E) durch eine bezüglich der Referenz (34) polaritätsabhängige Funktion ermittelt wird, und der Korrekturwert (K) aus einem Anteil (56) des Gleichsignal-unterdrückten Signalzugs (F) ermittelt wird, welcher gegenüber der Referenz eine entgegengesetzte Polarität zu der unipolaren Auslenkung hat, und der Korrekturwert (K) in Pausenzeiten (tp) zwischen Pulsen (48) ermittelt wird,
- und dieser Korrekturwert (K)vorzeichenrichtig zu dem Gleichsignal-unterdrückten Signalzug (F) addiert wird, wobei ein korrigierter Ergebnis-Signalzug (A) resultiert.

2. Verfahren nach Anspruch 1, **dadurch gekennzeichnet, dass** in dem ersten Anteil (42) des Start-Signalzugs (E) die Pulse (48) zwischen einem betragsmäßigen Minimalwert (30) und einem betragsmäßigen Maximalwert (32) liegen, wobei der betragsmäßige Minimalwert (30) bei der Referenz (34) liegt.

3. Verfahren nach Anspruch 1 oder 2, **dadurch gekennzeichnet, dass** ein nutzbarer Signalzug in Relation zu der Referenz (34) verwendet wird und insbesondere eine referenzbezogene Maximalwert-Auswertung durchgeführt wird.

4. Verfahren nach einem der vorangehenden Ansprüche, **dadurch gekennzeichnet, dass** Scheitelwerte von Pulsen im Ergebnis-Signalzug (A) in Relation zu der Referenz (34) mindestens näherungsweise gleich groß sind wie Scheitelwerte von Pulsen im ersten Anteil (42) des Start-Signalzug (E) in Relation zu der Referenz.

5. Verfahren nach einem der vorangehenden Ansprüche, **dadurch gekennzeichnet, dass** die Referenz (34) ein Referenzwert oder Referenzsignal ist und insbesondere ein Nullsignal oder ein Massepotential ist.

6. Verfahren nach einem der vorangehenden Ansprüche, **dadurch gekennzeichnet, dass** ein Signalzug aufgeteilt wird in einen ersten Split-Signalzug und einen zweiten Split-Signalzug, wobei an dem zweiten Split-Signalzug der Korrekturwert (K) bestimmt wird, und insbesondere, dass die Aufteilung vor einem Addierer (76) erfolgt, an dem der Korrekturwert (K) zu dem ersten Split-Signalzug addiert wird, wobei der aufgeteilte Signalzug der Gleichsignal-unterdrückte Signalzug (F) ist, und insbesondere, dass die Aufteilung nach einem Addierer (126) erfolgt, an dem der Korrekturwert (K) zu dem Gleichsignal-unterdrückten Signalzug (F) addiert wird, und insbesondere wobei der erste Split-Signalzug der korrigierte Ergebnis-Signalzug (A) ist.

7. Verfahren nach einem der vorangehenden Ansprüche, **dadurch gekennzeichnet, dass** der Korrekturwert (K) mittels eines Tiefpassfilters (84; 122; 176) und/oder Integrators (120; 152) ermittelt wird, und insbesondere, dass über eine polaritätsabhängige Funktion ein Signalweg zu dem Tiefpassfilter (84; 122; 176) und/oder Integrator (120; 152) unterbrochen oder freigegeben wird, wobei insbesondere bei einer zu der unipolaren Auslenkung entgegengesetzten Polarität in einem Signalzug der Signalweg freigegeben wird, und insbesondere, dass der Signalweg mittels eines Einweggleichrichters (82; 82') und/oder eines Schalters (102; 142) und/oder eines Komparators (104; 144; 162) unterbrochen oder freigegeben wird, und insbesondere, dass der Schalter (102; 142) über einen Komparator (104; 144) angesteuert wird, welcher einen Signalzug mit der Referenz (34) vergleicht.

8. Verfahren nach einem der vorangehenden Ansprüche, **dadurch gekennzeichnet, dass** eine Invertierung für den Korrekturwert (K) zur vorzeichenrichtigen Addition durchgeführt wird, und insbesondere, dass die Invertierung bei der Gewinnung des Korrekturwerts (K) durchgeführt wird oder an einem Addierer-Eingang durchgeführt wird.

9. Verfahren nach einem der vorangehenden Ansprüche, **dadurch gekennzeichnet, dass** an einem zweiten Split-Signalzug des Gleichsignal-unterdrückten Signalzugs (F) eine Einweggleichrichtung und anschließend eine Filterung und/oder Integration durchgeführt wird, und der sich daraus ergebende Korrekturwert (K) vorzeichenrichtig zu einem ersten Split-Signalzug des Gleichsignal-unterdrückten Signalzug (F) addiert wird.

10. Verfahren nach einem der Ansprüche 1 bis 8, **dadurch gekennzeichnet, dass** ein zweiter Split-Signalzug über einen Schalter (102) einem Tiefpassfilter (122) und/oder Integrator (120) zugeführt wird, wobei der Schalter (102) mittels eines Komparators (104) angesteuert wird, welcher den zweiten Split-Signalzug mit der Referenz (34) vergleicht, und bei zu der unipolaren Auslenkung entgegengesetzten Polarität einen Signalweg zu dem Tiefpassfilter (122) und/oder Integrator (120) schaltet, und der sich dann ergebende Korrekturwert (K) wird vorzeichenrichtig zu einem ersten Split-Signalzug des Gleichsignal-unterdrückten Signalzugs (F) addiert.

11. Verfahren nach einem der Ansprüche 1 bis 8, **dadurch gekennzeichnet, dass** eine polaritätsabhängige Funktion zur Ermittlung des Korrekturwerts (K) über einen Regelkreis (156) bestimmt wird, bei dem der Korrekturwert (K) vorzeichenrichtig zu dem Gleichsignal-unterdrückten Signalzug (F) addiert wird und aus dem resultierenden Signalzug ein erster Split-Signalzug abgezweigt wird, welcher der korrigierte Ergebnis-Signalzug (A) ist, und ein zweiter Split-Signalzug abgezweigt wird, an welchem der Korrekturwert (K) bestimmt wird, und insbesondere, dass der Korrekturwert (K) über einen Schalter (142) bestimmt wird, welcher mittels eines Komparators (144) angesteuert wird, wobei der Komparator (144) den zweiten Split-Signalzug mit der Referenz (34) vergleicht, und wobei der Schalter (142) über einen Signalweg mit dem Tiefpassfilter und/oder Integrator (152) verbunden ist, und insbesondere, dass der Korrekturwert (K) über einen Komparator (162) bestimmt wird, welcher den zweiten Split-Signalzug mit der Referenz (34) vergleicht und einen Tiefpassfilter (176) ansteuert, und insbesondere, dass der Komparator (162) über ein ODER-Glied (166) mit dem Tiefpassfilter (176) verbunden ist, wobei das ODER-Glied (166) über ein Steuersignal angesteuert ist, welches synchron zu dem Start-Signalzug (E) und/oder dem ersten Anteil (42) des Start-Signalzugs (E) ist.

12. Verfahren nach einem der vorangehenden Ansprüche, **dadurch gekennzeichnet, dass** der erste Anteil (42) des Start-Signalzugs (E) ein periodisches Messsignal oder Prüfsignal ist und der zweite Anteil ein Störanteil ist.

13. Mess- oder Prüfvorrichtung, umfassend
- eine Einheit (14), welche Start-Signalzüge (E) bereitstellt, die einen ersten Anteil (42) mit periodischen Pulsen (48) aufweisen, welche eine unipolare Auslenkung gegenüber einer Referenz (34) haben, und die einen zweiten Anteil (44) aufweisen können, welcher ein Störanteil mit Gleichsignalen ist,
- eine Signalbearbeitungseinrichtung (64; 64'; 92; 92'; 124; 158), welche korrigierte Ergebnis-Signalzüge (A) bereitstellt, wobei die Signalbearbeitungseinrichtung (64; 64'; 92; 92'; 124; 158) eine Gleichsignalunterdrückungseinrichtung (51) aufweist, welche aus den Start-Signalzügen (E) Gleichsignal-unterdrückte Signalzüge (F) erzeugt, dadurch gekennzeichtnet, dass die Signalbearbeitungseinrichtung (64; 64'; 92; 92'; 124; 158) eine Rückgewinnungseinrichtung (52; 78; 100; 138; 160) aufweist, welche aus den Gleichsignal-unterdrückten Signalzügen (F) einen Gleichanteil des ersten Anteils (42) der Start-Signalzüge als Korrekturwerte (K) ermittelt, wobei die Rückgewinnungseinrichtung (52; 78; 100; 138; 160) einen Tiefpassfilter (84; 122; 176) und/oder Integrator (120; 152) umfasst, welcher Korrekturwerte (K) bereitstellt, und wobei dem Tiefpassfilter (84; 122; 176) und/oder Integrator (120; 152) Signale über einen Einweggleichrichter (82; 82') und/oder Schalter (102; 142) und/oder Komparator (104; 144; 162) bereitgestellt sind, welche eine polaritätsabhängige Funktion in Bezug auf die Referenz (34) bereitstellen, und wobei die Signalbearbeitungseinrichtung (64; 64'; 92; 92'; 124; 158) einen Addierer (76; 126) aufweist, welcher zur Gewinnung der Ergebnis-Signalzüge (A) vorzeichenrichtig Korrekturwerte (K) zu den Gleichsignal-unterdrückten Signalzügen (F) addiert.

14. Mess- oder Prüfvorrichtung nach Anspruch 13, **gekennzeichnet durch** einen Splitter (68; 94; 132), welcher Signalzüge in erste Split-Signalzüge und zweite Split-Signalzüge aufteilt, wobei der Rückgewinnungseinrichtung (52; 78; 100; 138; 160) die zweiten Split-Signalzüge bereitgestellt sind, und insbesondere, dass der Splitter (68; 94) dem Addierer (76) vorgeschaltet ist, wobei an dem Splitter (68; 94) Gleichsignal-unterdrückte Signalzüge (F) in erste Split-Signalzüge und zweite Split-Signalzüge aufgeteilt werden und wobei an dem Addierer (76) Gleichsignal-unterdrückte Signalzüge (F) und Korrekturwerte (K), welche an den zweiten Split-Signalzügen ermittelt sind, addiert werden, und insbesondere, dass der Splitter (132) dem Addierer (126) nachgeschaltet ist, wobei der Addierer (126) Gleichsignal-unterdrückte Signalzüge (F) und Korrekturwerte (K) addiert und der Splitter (132) aus resultierenden Signalzügen erste Split-Signalzüge und zweite Split-Signalzüge abzweigt und die ersten Split-Signalzüge korrigierte Ergebnis-Signalzüge (A) sind.

15. Mess- oder Prüfvorrichtung nach Anspruch 13 oder 14, **gekennzeichnet durch** einen Schalter (102), welcher signalwirksam mit dem Tiefpassfilter (122) und/oder Integrator (120) verbunden ist, und welcher über einen Komparator (104) angesteuert ist, wobei der Komparator (104) Signalzüge mit der Referenz (34) vergleicht.

16. Mess- oder Prüfvorrichtung nach einem der Ansprüche 13 bis 15, **gekennzeichnet durch** einen Regelkreis (156) mit einem Splitter (132), welcher aus Ausgangs-Signalzügen des Addierers (126) erste Split-Signalzüge und zweite Split-Signalzüge abzweigt, wobei aus den zweiten Split-Signalzügen Korrekturwerte (K) bestimmt sind und die ersten Split-Signalzüge die korrigierten Ergebnis-Signalzüge (A) sind, und insbesondere, dass in der Rückgewinnungseinrichtung (138) ein Komparator (144) angeordnet ist, welcher zweite Split-Signalzüge mit der Referenz (34) vergleicht, und insbesondere, dass der Komparator (144) einen Schalter (142) und/oder einen Tiefpassfilter (176) und/oder Integrator ansteuert, und insbesondere, dass zwischen dem Komparator (162) und dem Tiefpassfilter (176) und/oder Integrator ein ODER-Glied (166) angeordnet ist, welches mit Steuersignalen angesteuert ist, welche synchron zu den Start-Signalzügen (E) und/oder dem ersten Anteil (42) der Start-Signalzüge (E) sind.

17. Mess- oder Prüfvorrichtung nach einem der Ansprüche 13 bis 16, **gekennzeichnet durch** eine Sendeeinrichtung (12), welche periodische Pulse und insbesondere periodisch gepulste Lichtsignale bereitstellt, und insbesondere eine Empfangseinheit (14), welche korreliert zu der Sendeeinheit Start-Signalzüge (E) bereitstellt.

## Claims

1. Method for processing a start signal train (E), which start signal train (E) comprises a first portion (42) having periodic pulses (48), wherein said pulses (48) are deflected in a unipolar manner with respect to a reference (34), and which can comprise a second portion (44) which is a disturbance portion having DC signals, in which method a DC-signal-rejected signal train (F) is generated from the start signal train (E), wherein
- the DC-signal-rejected signal train (F) is generated from the start signal train (E) by DC signal rejection or by AC signal coupling, **characterized in that**
- a DC portion of the first portion (42) of the start signal train (E) is determined as a correction value (K) from the DC-signal-rejected signal train (F), wherein the correction value (K) for recovering the DC portion of the first portion (42) of the start signal train (E) is determined by a polarity-dependent function with respect to the reference (34), and the correction value (K) is determined from a portion (56) of the DC-signal-rejected signal train (F) which has, relative to the reference, a polarity that is opposite the unipolar deflection, and the correction value (K) is determined in pause times (tp) between pulses (48),
- and said correction value (K) is added, with the proper sign, to the DC-signal-rejected signal train (F), wherein a corrected result signal train (A) results.

2. Method in accordance with claim 1, **characterized in that**, in the first portion (42) of the start signal train (E), the pulses (48) lie between a magnitude-wise minimum value (30) and a magnitude-wise maximum value (32), wherein the magnitude-wise minimum value (30) is at the reference (34).

3. Method in accordance with claim 1 or 2, **characterized in that** a usable signal train is used in relation to the reference (34), and in particular **in that** a reference-related maximum value evaluation is carried out.

4. Method in accordance with any one of the preceding claims, **characterized in that** crest values of pulses in the result signal train (A) are, in relation to the reference (34), at least approximately the same magnitude as crest values of pulses in the first portion (42) of the start signal train (E) in relation to the reference.

5. Method in accordance with any one of the preceding claims, **characterized in that** the reference (34) is a reference value or a reference signal and is, in particular, a zero signal or a ground potential.

6. Method in accordance with any one of the preceding claims, **characterized in that** a signal train is split into a first split signal train and a second split signal train, wherein the correction value (K) is determined at the second split signal train, and in particular **in that** the splitting is realized upstream of an adder (76) at which the correction value (K) is added to the first split signal train, wherein the split signal train is the DC-signal-rejected signal train (F), and in particular **in that** the splitting is realized downstream of an adder (126) at which the correction value (K) is added to the DC-signal-rejected signal train (F), and in particular wherein the first split signal train is the corrected result signal train (A).

7. Method in accordance with any one of the preceding claims, **characterized in that** the correction value (K) is determined by way of a low-pass filter (84; 122; 176) and/or an integrator (120; 152), and in particular **in that** a signal path to the low-pass filter (84; 122; 176) and/or integrator (120; 152) is interrupted or released via a polarity-dependent function, in particular wherein in a signal train, when polarity is opposite the unipolar deflection, the signal path is released, and in particular **in that** the signal path is interrupted or released by way of a half-wave rectifier (82; 82') and/or a switch (102; 142) and/or a comparator (104; 144; 162), and in particular **in that** the switch (102; 142) is controlled via a comparator (104; 144) which compares a signal train to the reference (34).

8. Method in accordance with any one of the preceding claims, **characterized in that** an inversion is performed for the correction value (K) for effecting the addition operation with the proper sign, and in particular **in that** said inversion is performed when the correction value (K) is obtained or is performed at an adder input.

9. Method in accordance with any one of the preceding claims, **characterized in that** a half-wave rectification followed by filtering and/or integration is performed at a second split signal train of the DC-signal-rejected signal train (F), and the correction value (K) resulting therefrom is added, with the proper sign, to a first split signal train of the DC-signal-rejected signal train (F).

10. Method in accordance with any one of claims 1 to 8, **characterized in that** a second split signal train is fed via a switch (102) to a low-pass filter (122) and/or an integrator (120), wherein the switch (102) is controlled by way of a comparator (104) which compares the second split signal train to the reference (34) and which, when polarity is opposite to that of the unipolar deflection, switches a signal path to the low-pass filter (122) and/or integrator (120), and the then resulting correction value (K) is added, with the proper sign, to a first split signal train of the DC-signal-rejected signal train (F).

11. Method in accordance with any one of claims 1 to 8, **characterized in that** a polarity-dependent function for determining the correction value (K) is determined via a control loop (156) in which the correction value (K) is added, with the proper sign, to the DC-signal-rejected signal train (F) and in which, from the resulting signal train, a first split signal train is branched off which is the corrected result signal train (A), and a second split signal train is branched off at which the correction value (K) is determined, and in particular **in that** the correction value (K) is determined via a switch (142) which is controlled by way of a comparator (144), wherein the comparator (144) compares the second split signal train to the reference (34), and wherein the switch (142) is connected via a signal path to the low-pass filter and/or integrator (152), and in particular **in that** the correction value (K) is determined via a comparator (162) which compares the second split signal train to the reference (34) and controls a low-pass filter (176), and in particular **in that** the comparator (162) is connected to the low-pass filter (176) via an OR element (166), wherein the OR element (166) is controlled via a control signal that is synchronous to the start signal train (E) and/or to the first portion (42) of the start signal train (E).

12. Method in accordance with any one of the preceding claims, **characterized in that** the first portion (42) of the start signal train (E) is a periodic measurement signal or test signal and **in that** the second portion is a disturbance portion.

13. Measuring or testing apparatus, comprising:
- a unit (14) which provides start signal trains (E), which start signal trains (E) comprise a first portion (42) having periodic pulses (48), said pulses (48) having a unipolar deflection with respect to a reference (34), and which can comprise a second portion (44) which is a disturbance portion having DC signals,
- a signal processing device (64; 64'; 92; 92'; 124; 158) which provides corrected result signal trains (A), wherein the signal processing device (64; 64'; 92; 92'; 124; 158) comprises a DC signal rejection device (51) which generates DC-signal-rejected signal trains (F) from the start signal trains (E), **characterized in that** the signal processing device (64; 64'; 92; 92'; 124; 158) comprises a recovery device (52; 78; 100; 138; 160) which determines, from the DC-signal-rejected signal trains (F), a DC portion of the first portion (42) of the start signal trains as correction values (K), wherein the recovery device (52; 78; 100; 138; 160) comprises a low-pass filter (84; 122; 176) and/or an integrator (120; 152) which provides correction values (K), and wherein signals are provided to the low-pass filter (84; 122; 176) and/or integrator (120; 152) via a half-wave rectifier (82; 82') and/or switch (102; 142) and/or comparator (104; 144; 162) which provide a polarity-dependent function with respect to the reference (34), and wherein the signal processing device (64; 64'; 92; 92'; 124; 158) comprises an adder (76; 126) which adds, with the proper sign, correction values (K) to the DC-signal-rejected signal trains (F) for obtaining the result signal trains (A).

14. Measuring or testing apparatus in accordance with claim 13, **characterized by** a splitter (68; 94; 132) which splits signal trains into first split signal trains and second split signal trains, wherein the second split signal trains are provided to the recovery device (52; 78; 100; 138; 160), and in particular **characterized in that** the splitter (68; 94) is upstream of the adder (76), wherein DC-signal-rejected signal trains (F) are split into first split signal trains and second split signal trains at the splitter (68; 94), and wherein DC-signal-rejected signal trains (F) and correction values (K) which are determined at the second split signal trains are added at the adder (76), and in particular **in that** the splitter (132) is downstream of the adder (126), wherein the adder (126) adds DC-signal-rejected signal trains (F) and correction values (K), and wherein the splitter (132) branches off first split signal trains and second split signal trains from resulting signal trains, and wherein the first split signal trains are corrected result signal trains (A).

15. Measuring or testing apparatus in accordance with claim 13 or 14, **characterized by** a switch (102) which is operatively connected to the low-pass filter (122) and/or integrator (120) for signal communication therewith and which is controlled via a comparator (104), wherein the comparator (104) compares signal trains to the reference (34).

16. Measuring or testing apparatus in accordance with any one of claims 13 to 15, **characterized by** a control loop (156) having a splitter (132) which branches off first split signal trains and second split signal trains from output signal trains of the adder (126), wherein correction values (K) are determined from the second split signal trains and the first split signal trains are the corrected result signal trains (A), and in particular **characterized in that** arranged in the recovery device (138) is a comparator (144) which compares second split signal trains to the reference (34), and in particular **in that** the comparator (144) controls a switch (142) and/or a low-pass filter (176) and/or an integrator, and in particular **in that** arranged between the comparator (162) and the low-pass filter (176) and/or integrator is an OR element (166) which is controlled by control signals that are synchronous to the start signal trains (E) and/or the first portion (42) of the start signal trains (E).

17. Measuring or testing apparatus in accordance with any one of claims 13 to 16, **characterized by** a transmit device (12) which provides periodic pulses, and provides periodically pulsed light signals in particular, and in particular **characterized by** a receive unit (14) which provides start signal trains (E) in a manner correlated with the transmit unit.

## Revendications

1. Procédé de traitement d'un train de signaux de départ (E), lequel comprend une première portion (42) avec des impulsions (48) périodiques, dans lequel les impulsions (48) sont déviées de façon unipolaire vers une référence (34), et peut comprendre une seconde portion (44), laquelle est une portion de perturbation avec des signaux continus avec laquelle à partir du train de signaux de départ (E) est produit un train de signaux inhibé à signal continu (F), dans lequel :
- le train de signaux inhibé à signal continu (F) est produit à partir du train de signaux de départ (E) par inhibition de signal continu ou couplage de signal alternatif, **caractérisé en ce que**
- à partir du train de signaux inhibé à signal continu (F) est établie en tant que valeur de correction (K) une portion continue de la première portion (42) du train de signaux de départ (E), dans lequel la valeur de correction (K) pour la récupération de la portion continue de la première portion (42) du train de signaux de départ (E) est établie par une fonction dépendante de la polarité relativement à la référence (34), et la valeur de correction (K) est établie à partir d'une portion (56) du train de signaux inhibé à signal continu (F), lequel présente vis-à-vis de la référence une polarité opposée à la déviation unipolaire, et la valeur de correction (K) est établie dans des temps de pause (tp) entre des impulsions (48),
- et cette valeur de correction (K) est additionnée avec le bon signe au train de signaux inhibé à signal continu (F), dans lequel résulte un train de signaux de résultat (A) corrigé.

2. Procédé selon la revendication 1, **caractérisé en ce que** dans la première portion (42) du train de signaux de départ (E) les impulsions (48) se situent entre une valeur minimale (30) en valeur absolue et une valeur maximale (32) en valeur absolue, dans lequel la valeur minimale (30) en valeur absolue se situe au niveau de la référence (34).

3. Procédé selon la revendication 1 ou 2, **caractérisé en ce qu'**un train de signaux utilisable est employé en lien avec la référence (34) et une évaluation de valeur maximale est en particulier réalisée relativement à la référence.

4. Procédé selon l'une des revendications précédentes, **caractérisé en ce que** des valeurs de crête d'impulsions dans le train de signaux de résultat (A) en relation avec la référence (34) sont au moins approximativement identiques aux valeurs de crête d'impulsions dans la première portion (42) du train de signaux de départ (E) en relation avec la référence.

5. Procédé selon l'une des revendications précédentes, **caractérisé en ce que** la référence (34) est une valeur de référence ou un signal de référence et est en particulier un signal zéro ou un potentiel de terre.

6. Procédé selon l'une des revendications précédentes, **caractérisé en ce qu'**un train de signaux est divisé en un premier train de signaux de division et un second train de signaux de division, dans lequel la valeur de correction (K) est déterminée au niveau du second train de signaux de division, et en particulier **en ce que** la division survient avant un additionneur (76) au niveau duquel la valeur de correction (K) est additionnée au premier train de signaux de division, dans lequel le train de signaux de division est le train de signaux inhibé à signal continu (F), et en particulier **en ce que** la division survient après un additionneur (126) au niveau duquel la valeur de correction (K) est additionnée au train de signaux inhibé à signal continu (F), et en particulier dans lequel le premier train de signaux de division est le train de signaux de résultat (A) corrigé.

7. Procédé selon l'une des revendications précédentes, **caractérisé en ce que** la valeur de correction (K) est établie au moyen d'un filtre passe-bas (84 ; 122 ; 176) et/ou d'un intégrateur (120 ; 152), et en particulier **en ce qu'**un trajet de signal vers le filtre passe-bas (84 ; 122 ; 176) et/ou l'intégrateur (120 ; 152) est interrompu ou libéré via une fonction dépendante de la polarité, dans lequel en particulier le trajet de signal est libéré lors d'une polarité opposée à la déviation unipolaire dans un train de signaux, et en particulier **en ce que** le trajet de signal est interrompu ou libéré au moyen d'un redresseur à une alternance (82 ; 82') et/ou d'un commutateur (102 ; 142) et/ou d'un comparateur (104 ; 144 ; 162), et en particulier **en ce que** le commutateur (102 ; 142) est piloté via un comparateur (104 ; 144), lequel compare un train de signaux avec la référence (34).

8. Procédé selon l'une des revendications précédentes, **caractérisé en ce qu'**une inversion pour la valeur de correction (K) est réalisée pour l'addition avec le bon signe, et en particulier **en ce que** l'inversion est réalisée lors de l'obtention de la valeur de correction (K) ou est réalisée au niveau d'une entrée d'additionneur.

9. Procédé selon l'une des revendications précédentes, **caractérisé en ce qu'**au niveau d'un second train de signaux de division du train de signaux inhibé à signal continu (F) est réalisé un redressement à une alternance puis un filtrage et/ou une intégration, et la valeur de correction (K) qui en découle est additionnée avec le bon signe à un premier train de signaux de division du train de signaux inhibé à signal continu (F) .

10. Procédé selon l'une des revendications 1 à 8, **caractérisé en ce qu'**un second train de signaux de division est amené via un commutateur (102), un filtre passe-bas (122) et/ou un intégrateur (120), dans lequel le commutateur (102) est piloté au moyen d'un comparateur (104), lequel compare le second train de signaux de division avec la référence (34), et commute un trajet de signal vers le filtre passe-bas (122) et/ou l'intégrateur (120) au niveau de la polarité opposée à la déviation unipolaire, et la valeur de correction (K) en découlant alors est additionnée avec le bon signe à un premier train de signaux de division du train de signaux inhibé à signal continu (F).

11. Procédé selon l'une des revendications 1 à 8, **caractérisé en ce qu'**une fonction dépendante de la polarité pour établir la valeur de correction (K) est déterminée via un circuit de réglage (156) où la valeur de correction (K) est additionnée avec le bon signe au train de signaux inhibé à signal continu (F) et à partir du train de signaux résultant est branché un premier train de signaux de division, lequel est le train de signaux de résultat (A) corrigé, et un second train de signaux de division est branché, au niveau duquel la valeur de correction (K) est déterminée, et en particulier **en ce que** la valeur de correction (K) est déterminée via un commutateur (142), lequel est piloté au moyen d'un comparateur (144), dans lequel le comparateur (144) compare le second train de signaux de division avec la référence (34), et dans lequel le commutateur (142) est relié au filtre passe-bas et/ou à l'intégrateur (152) via un trajet de signal, et en particulier **en ce que** la valeur de correction (K) est déterminée via un comparateur (162), lequel compare le second train de signaux de division avec la référence (34) et pilote un filtre passe-bas (176), et en particulier **en ce que** le comparateur (162) est relié au filtre passe-bas (176) via un élément OU (166), dans lequel l'élément OU (166) est piloté via un signal de commande, lequel est synchronisé avec le train de signaux de départ (E) et/ou la première portion (42) du train de signaux de départ (E).

12. Procédé selon l'une des revendications précédentes, **caractérisé en ce que** la première portion (42) du train de signaux de départ (E) est un signal de mesure ou un signal de vérification périodique et la seconde portion est une portion de perturbation.

13. Dispositif de mesure ou de vérification, comprenant
- une unité (14), laquelle fournit des trains de signaux de départ (E) qui présentent une première portion (42) avec des impulsions (48) périodiques, lesquelles ont une déviation unipolaire vis-à-vis d'une référence (34), et qui peuvent présenter une seconde portion (44), laquelle est une portion de perturbation avec des signaux continus,
- un équipement de traitement de signal (64 ; 64' ; 92 ; 92' ; 124 ; 158), lequel fournit des trains de signaux de résultat (A) corrigés, dans lequel l'équipement de traitement de signal (64 ; 64' ; 92 ; 92' ; 124 ; 158) présente un équipement d'inhibition de signal continu (51), lequel produit des trains de signaux inhibés à signal continu (F) à partir des trains de signaux de départ (E), **caractérisé en ce que**
l'équipement de traitement de signal (64 ; 64' ; 92 ; 92' ; 124 ; 158) présente un équipement de récupération (52 ; 78 ; 100 ; 138 ; 160), lequel établit à partir des trains de signaux inhibés à signal continu (F) une portion continue de la première portion (42) des trains de signaux de départ en tant que valeur de correction (K), dans lequel l'équipement de récupération (52 ; 78 ; 100 ; 138 ; 160) comprend un filtre passe-bas (84 ; 122 ; 176) et/ou un intégrateur (120 ; 152), lequel fournit des valeurs de correction (K), et dans lequel des signaux sont fournis au filtre passe-bas (84 ; 122 ; 176) et/ou à l'intégrateur (120 ; 152) via un redresseur à une alternance (82 ; 82') et/ou un commutateur (102 ; 142) et/ou un comparateur (104 ; 144 ; 162), lesquels fournissent une fonction dépendante de la polarité relativement à la référence (34), et dans lequel l'équipement de traitement de signal (64 ; 64' ; 92 ; 92' ; 124 ; 158) présente un additionneur (76 ; 126), lequel additionne des valeurs de correction (K) avec le bon signe aux trains de signaux inhibés à signal continu (F) pour obtenir les trains de signaux de résultat (A).

14. Dispositif de mesure ou de vérification selon la revendication 13, **caractérisé par** un répartiteur (68 ; 94 ; 132), lequel divise des trains de signaux en premiers trains de signaux de division et seconds trains de signaux de division, dans lequel les seconds trains de signaux de division sont fournis à l'équipement de récupération (52 ; 78 ; 100 ; 138 ; 160), et en particulier en ce que le répartiteur (68 ; 94) est monté en amont de l'additionneur (76), dans lequel des trains de signaux inhibés à signal continu (F) sont divisés en premiers trains de signaux de division et seconds trains de signaux de division au niveau du répartiteur (68 ; 94) et dans lequel sont additionnés au niveau de l'additionneur (76) des trains de signaux inhibés à signal continu (F) et des valeurs de correction (K), lesquelles sont établies au niveau des seconds trains de signaux de division, et en particulier en ce que le répartiteur (132) est monté en aval de l'additionneur (126), dans lequel l'additionneur (126) additionne des trains de signaux inhibés à signal continu (F) et des valeurs de correction (K) et le répartiteur (132) branche des premiers trains de signaux de division et des seconds trains de signaux de division à partir de trains de signaux résultants, et les premiers trains de signaux de division sont des trains de signaux de résultat (A) corrigés.

15. Dispositif de mesure ou de vérification selon la revendication 13 ou 14, **caractérisé par** un commutateur (102), lequel est relié efficacement par signal avec le filtre passe-bas (122) et/ou l'intégrateur (120), et lequel est piloté via un comparateur (104), dans lequel le comparateur (104) compare des trains de signaux avec la référence (34).

16. Dispositif de mesure ou de vérification selon l'une des revendications 13 à 15, **caractérisé par** un circuit de réglage (156) avec un répartiteur (132), lequel branche des premiers trains de signaux de division et des seconds trains de signaux de division à partir de trains de signaux de sortie de l'additionneur (126), dans lequel des valeurs de correction (K) sont déterminées à partir des seconds trains de signaux de division et les premiers trains de signaux de division sont les trains de signaux de résultat (A) corrigés, et en particulier en ce que dans l'équipement de récupération (138) est agencé un comparateur (144), lequel compare des seconds trains de signaux de division avec la référence (34), et en particulier en ce que le comparateur (144) pilote un commutateur (142) et/ou un filtre passe-bas (176) et/ou un intégrateur, et en particulier en ce qu'entre le comparateur (162) et le filtre passe-bas (176) et/ou l'intégrateur est agencé un élément OU (166), lequel est piloté avec des signaux de commande, lesquels sont synchronisés avec les trains de signaux de départ (E) et/ou la première portion (42) des trains de signaux de départ (E).

17. Dispositif de mesure ou de vérification selon l'une des revendications 13 à 16, **caractérisé par** un équipement d'envoi (12), lequel fournit des impulsions périodiques et en particulier des signaux lumineux périodiquement pulsés, et en particulier une unité de réception (14), laquelle fournit des trains de signaux de départ (E) en corrélation avec l'unité d'envoi.
